# EUROPEAN PATENT APPLICATION

(11) **EP 4 756 565 A1**
(43) Date of publication of application: **10.06.2026**
(21) Application number: 24901037.2
(22) Date of filing: 03.12.2024
(51) Int. Cl.: G06F 1/16, G06F 1/18, G06F 1/20, G06F 3/041

(54) **FLEXIBLE DISPLAY AND ELECTRONIC DEVICE COMPRISING SAME**

(30) Priority: 04.12.2023 KR 20230173777; 17.01.2024 KR 20240007575
(71) Applicant: Samsung Electronics Co., Ltd., Suwon-si, Gyeonggi-do 16677 (KR)
(72) Inventor: KANG, Jooyoung, Suwon-si, Gyeonggi-do 16677 (KR); KIM, Bongsoo, Suwon-si, Gyeonggi-do 16677 (KR); PARK, Sejin, Suwon-si, Gyeonggi-do 16677 (KR); BYUN, Wanju, Suwon-si, Gyeonggi-do 16677 (KR); YUN, Inkuk, Suwon-si, Gyeonggi-do 16677 (KR); CHO, Sujeong, Suwon-si, Gyeonggi-do 16677 (KR); HONG, Hyunju, Suwon-si, Gyeonggi-do 16677 (KR)
(74) Representative: Gulde & Partner
(86) International application number: PCT/KR2024/019630
(87) International publication number: WO 2025/121851

(57) **Abstract**

According to an embodiment of the present disclosure, an electronic device may include: a flexible display; a first substrate which at least partially overlaps the flexible display and is electrically connected to the flexible display; a display driving integrated circuit positioned on the first substrate; a second substrate which at least partially overlaps the first substrate, is electrically connected to the first substrate, and includes an accommodation portion for accommodating at least a part of the display driving integrated circuit; and a shielding structure positioned on the second substrate and configured to cover the accommodation portion and shield the display driving integrated circuit.

## Description

### [TECHNICAL FIELD]

Various embodiments of the disclosure relate to an electronic device and, for example, to a flexible display and an electronic device including the same.

### [BACKGROUND ART]

With the remarkable advancements in information and communication technology and semiconductor technology, the spread and utilization of various electronic devices are increasing rapidly. Particularly, recent electronic devices are being developed to enable communication while being carried.

Electronic devices may refer to devices that perform specific functions based on embedded programs, such as home appliances, electronic notes, portable multimedia players (PMPs), mobile communication terminals, tablet personal computers (PCs), video/audio devices, desktop/laptop computers, vehicle navigation systems, and so forth. For example, these electronic devices may output stored information in the form of sound or images. With the increasing integration of electronic devices and the common use of ultrahigh-speed and large-volume wireless communication, various functions have recently come to be provided in a single electronic device, such as a mobile communication terminal. For example, various functions such as an entertainment function such as gaming, a multimedia function such as music/video playback, a communication and security function for mobile banking, and a function such as a schedule management or electronic wallet, as well as a communication function have been integrated into a single electronic device. Such electronic devices have become compact such that users can conveniently carry and wear them.

As mobile communication services expand to include multimedia services, the size of the display of electronic devices may increase to allow users to fully utilize multimedia services as well as voice calls and text messages.

The above-described information may be provided as background art to aid in understanding the disclosure. No admission is made as to whether any of the above-described contents can be applied as prior art related to the disclosure.

### [DETAILED DESCRIPTION OF THE INVENTION]

### [TECHNICAL SOLUTION]

According to embodiment of the disclosure, an electronic device may be provided and include: a flexible display; a first board at least partially overlapping the flexible display and electrically connected to the flexible display; a display driver integrated circuit on the first board; a second board at least partially overlapping the first board, electrically connected to the first board, and including an accommodation portion accommodating at least a part of the display driver integrated circuit; and a shielding structure on the second board, covering the accommodation portion, and configured to shield the display driver integrated circuit.

According to embodiment of the disclosure, an electronic device may be provided and include: a housing including a first housing portion and a second housing portion configured to move with respect to the first housing portion in a first direction; a flexible display on the housing; a first board on the flexible display; a display driver integrated circuit on the first board; a second board on the first board in a second direction different from the first direction, electrically connected to the first board, and including an accommodation portion accommodating at least a part of the display driver integrated circuit; and a shielding structure on the second board, electrically connected to a ground plane of the second board, and covering the display driver integrated circuit.

### [BRIEF DESCRIPTION OF DRAWINGS]

FIG. 1 is a block diagram illustrating an electronic device in a network environment, according to various embodiments of the disclosure;
FIG. 2A is a first side view illustrating a state in which a second display area of a display is received in an electronic device, according to an embodiment of the disclosure;
FIG. 2B is a front view illustrating the state in which the second display area of the display is received in the electronic device of FIG. 2A, according to an embodiment of the disclosure;
FIG. 2C is a rear view illustrating the state in which the second display area of the display is received in the electronic device of FIG. 2A, according to an embodiment of the disclosure;
FIG. 2D is a second side view illustrating the state in which the second display area of the display is received in the electronic device of FIG. 2A, according to an embodiment of the disclosure;
FIG. 3A is a first side view illustrating a state in which a second display area of a display is visually exposed to an outside of an electronic device, according to an embodiment of the disclosure;
FIG. 3B is a front view illustrating the state in which the second display area of the display is visually exposed to the outside of the electronic device of FIG. 3A, according to an embodiment of the disclosure;
FIG. 3C is a rear view illustrating the state in which the second display area of the display is visually exposed to the outside of the electronic device of FIG. 3A, according to an embodiment of the disclosure;
FIG. 3D is a second side view illustrating the state in which the second display area of the display is visually exposed to the outside of the electronic device of FIG. 3A, according to an embodiment of the disclosure;
FIG. 4 is an exploded perspective view illustrating an electronic device, according to an embodiment of the disclosure;
FIG. 5A is a cross-sectional view taken along a line A-A' of FIG. 2B, according to an embodiment of the disclosure;
FIG. 5B is a cross-sectional view taken along a line B-B' of FIG. 3B, according to an embodiment of the disclosure;
FIG. 6 is a perspective view of a display assembly, according to an embodiment of the disclosure;
FIG. 7 is an exploded perspective view of a display assembly including a first board and a second board, according to an embodiment of the disclosure;
FIG. 8 is an exploded perspective view of a display assembly including a first board and a second board, according to an embodiment of the disclosure;
FIG. 9 is a rear view of a display assembly, according to an embodiment of the disclosure;
FIG. 10 is a rear view of a display assembly, according to an embodiment of the disclosure;
FIG. 11 is a rear view of a display assembly, according to an embodiment of the disclosure;
FIG. 12 is a rear view of a display assembly according to an embodiment of the disclosure;
FIG. 13 is a rear view of a display assembly, according to an embodiment of the disclosure;
FIG. 14 is a cross-sectional perspective view taken along a line C-C' of FIG. 9, according to an embodiment of the disclosure;
FIG. 15 is a cross-sectional perspective view taken along the line C-C' of FIG. 9, according to an embodiment of the disclosure;
FIG. 16 is a cross-sectional view of an electronic device, according to an embodiment;
FIG. 17 is an enlarged view of a part D in FIG. 16, according to an embodiment of the disclosure;
FIG. 18 is an enlarged view of the part D in FIG. 16, according to an embodiment of the disclosure; and
FIG. 19 is a cross-sectional perspective view of an electronic device taken along a line E-E' of FIG. 2C according to an embodiment of the disclosure.

### [MODE FOR THE INVENTION]

Embodiments of the disclosure are now described with reference to the accompanying drawings in such a detailed manner as to be easily practiced by one of ordinary skill in the art. However, embodiments of the disclosure may be implemented in other various forms and is not limited to the example embodiments set forth herein. The same or similar reference denotations may be used to refer to the same or similar elements throughout the specification and the drawings. Further, for clarity and brevity, description of well-known functions and configurations may be omitted in the drawings and relevant descriptions.

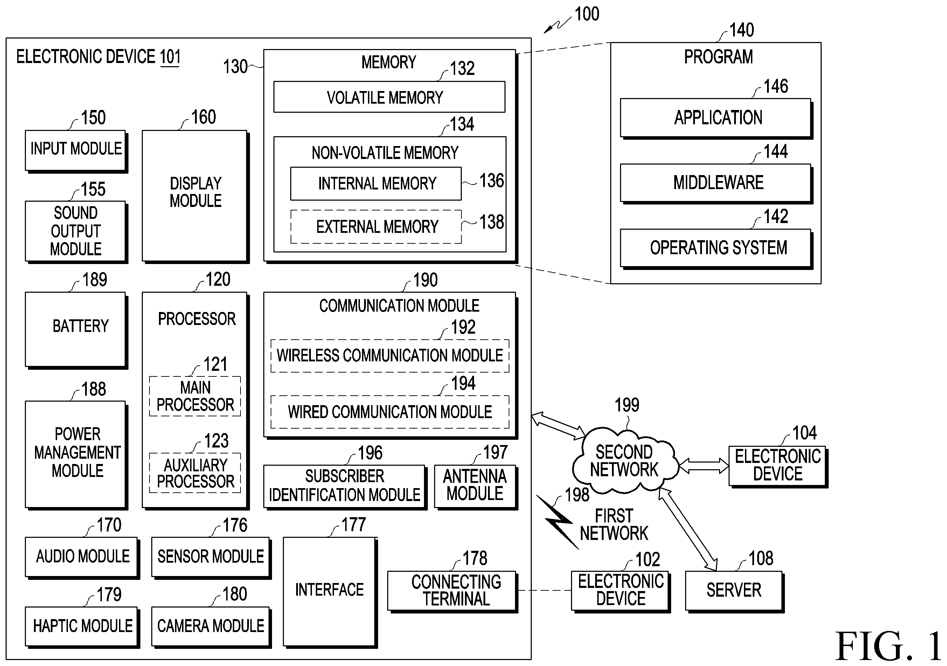

FIG. 1 is a block diagram illustrating an electronic device 101 in a network environment 100 according to various embodiments.

Referring to FIG. 1, the electronic device 101 in the network environment 100 may communicate with an external electronic device 102 via a first network 198 (e.g., a short-range wireless communication network), or an external electronic device 104 or a server 108 via a second network 199 (e.g., a long-range wireless communication network). According to an embodiment, the electronic device 101 may communicate with the external electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a second sensor module configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the external electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the external electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a board (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

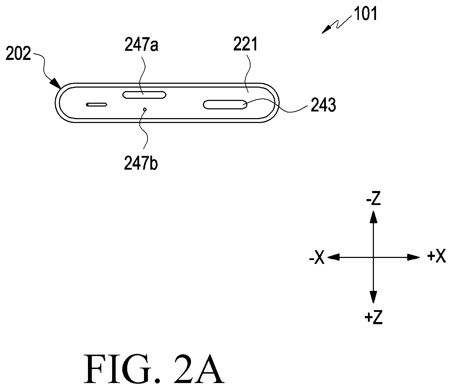

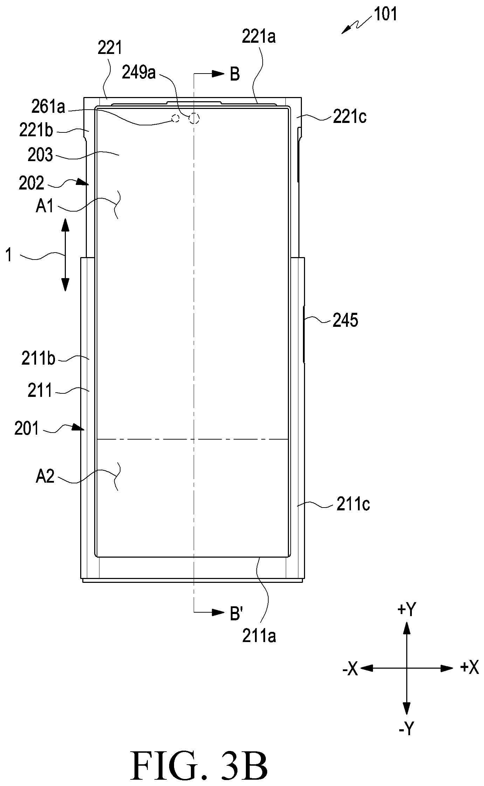

FIGS. 2A-D are diagrams illustrating a state in which a second display area (e.g., a display area A2 of FIG. 3B) of a display is received in the electronic device 101, according to an embodiment of the disclosure. The second display area, extending from the first display area, may be at least partially hidden inside the electronic device on a different plane from a plane of the first display area.

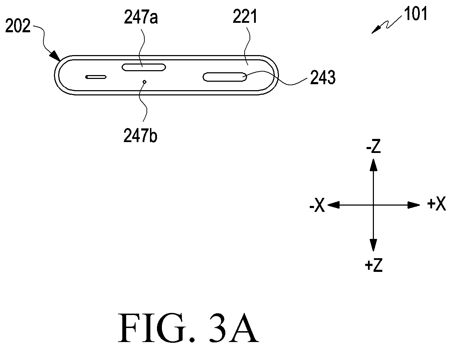

FIGS. 3A-D are diagrams illustrating a state in which a second display area of a display is visually exposed to an outside of an electronic device, according to an embodiment of the disclosure. The second display area, extending from the first display area, may be at least partially visually shown from the outside of the electronic device on substantially the same plane as a plane of the first display area, based on the movement of the second housing portion.

FIGS. 2A-D and 3A-D illustrate a structure in which a display 203 (e.g., flexible display or rollable display) is extendable in a longitudinal direction (e.g., +Y direction) when the electronic device 101 is viewed from the front. However, the extending direction of the display 203 is not limited to one direction (e.g., +Y direction). For example, the extending direction of the display 203 may be configured such that the display 203 is extendable in the upwards direction (e.g., +Y direction), the right direction (e.g., +X direction), the left direction (e.g., -X direction), and/or the downwards direction (e.g., -Y direction).

The state illustrated in FIGS. 2A-D may indicate a state where virtually the entire second display area, on a different plane from a plane of the first display area, is hidden inside the electronic device. For example, the state illustrated in FIGS. 2A-D may be referred to as a slide-in state of the electronic device 101 or a closed state of the second display area A2 of the display 203.

The state illustrated in FIGS. 3A-D may indicate a state where the area of the second display area that is visually exposed to the outside of the electronic device is maximized, on substantially the same plane as a plane of the first display area. For example, the state illustrated in FIGS. 3A-D may be referred to as a slide-out state of the electronic device 101 or an open state of the second display area A2 of the display 203.

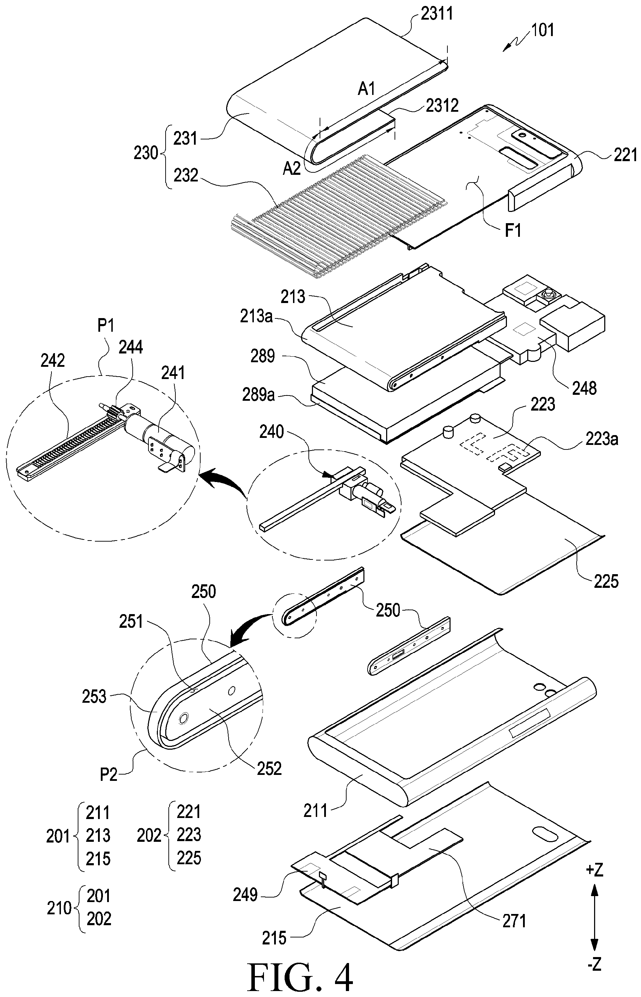

The embodiments of FIGS. 2A-D and FIGS. 3A-D may be combined with the embodiment of FIG. 1 or the embodiments of FIGS 4 to 19.

Referring to FIGS. 2A-D and FIGS. 3A-D, an electronic device 101 (e.g., the electronic device 101 of FIG. 1) may include a housing 210. The housing 210 may include a first housing portion 201 and a second housing portion 202 disposed to be movable relative to the first housing portion 201. In an embodiment, the electronic device 101 may have a structure in which the first housing portion 201 is disposed to be slidable with respect to the second housing portion 202. According to an embodiment, the second housing portion 202 may be disposed to perform a reciprocating motion by a predetermined distance in the illustrated direction relative to the first housing portion 201, for example, in a direction 1 of FIG. 3B. The first housing portion 201 may be referred to as a first housing, and the second housing portion 202 may be referred to as a second housing.

According to an embodiment, the second housing portion 202 may be referred to as a slide portion or a slide housing, and may be movable relative to the first housing portion 201. According to an embodiment, the second housing portion 202 may accommodate various electrical and electronic components, such as a circuit board or a battery. When the electronic device 101 is in the slide-in state, the second housing portion 202 may be defined as being in a retracted position, and when the electronic device 101 is in the slide-out state, the second housing portion 202 may be defined as being in an extended position. For example, the second housing portion 202 may be configured to move between the retracted position and the extended position relative to the first housing portion 201.

According to an embodiment, the slide-in state of the electronic device 101 (or the slide-out state of the electronic device 101) may be changed to the slide-out state of the electronic device 101 (or the slide-in state of the electronic device 101) based on a predefined user input. For example, the slide-in state of the electronic device 101 (or the slide-out state of the electronic device 101) may be changed to the slide-out state (or the slide-in state of the electronic device 101) in response to a user input to a physical button exposed through a portion of the first housing portion 201 or a portion of the second housing portion 202. For example, the slide-in state (or the slide-out state of the electronic device 101) may be changed to the slide-out state (or the slide-in state of the electronic device 101) in response to a touch input to an executable object displayed in a screen display area (e.g., the first display area A1). For example, the slide-in state (or the slide-out state of the electronic device 101) may be changed to the slide-out state (or the slide-in state of the electronic device 101) in response to a touch input that has a pressing intensity at or above a reference intensity at a contact point, on the screen display area (e.g., the first display area A1). For example, the slide-in state (or the slide-out state of the electronic device 101) may be changed to the slide-out state (or the slide-in state of the electronic device 101) in response to a voice input received through the microphone of the electronic device 101. For example, the slide-in state (or the slide-out state of the electronic device 101) may be changed to the slide-out state (or the slide-in state of the electronic device 101) in response to an external force applied to either the first housing portion 201 and/or the second housing portion 202 to move the second housing portion 202 relative to the first housing portion 201. For example, the slide-in state (or the slide-out state of the electronic device 101) may be changed to the slide-out state (or the slide-in state of the electronic device 101) in response to a user input identified by an external electronic device (e.g., earbuds or a smart watch) connected to the electronic device 101. However, methods of the disclosure that trigger the slide-in/out operation of the electronic device 101 are not limited to these examples.

According to an embodiment, the first housing portion 201 may accommodate an actuator (e.g., a motor), a speaker, a SIM socket, and/or a sub circuit board electrically connected with a main circuit board. The second housing portion 202 may accommodate the main circuit board on which electrical components, such as an application processor (AP) and a communication processor (CP) are mounted. According to an embodiment, the second housing portion 202 may accommodate the actuator, the speaker, the SIM socket, and/or the sub circuit board electrically connected with the main circuit board, and the first housing portion 201 may accommodate the main circuit board where electrical components, such as an application processor (AP) or a communication processor (CP), are mounted. According to an embodiment, both the sub circuit board and the main circuit board may be disposed in the first housing portion 201 or the second housing portion 202.

According to an embodiment, the first housing portion 201 may include a first cover member 211 (or main case). The first cover member 211 may include a (1-1)th sidewall 211a, a (1-2)th sidewall 211b extending from the (1-1)th sidewall 211a, and a (1-3)th sidewall 211c extending from the (1-1)th sidewall 211a and substantially parallel to the (1-2)th sidewall 211b. According to an embodiment, the (1-2)th sidewall 211b and the (1-3)th sidewall 211c may be formed substantially perpendicular to the (1-1)th sidewall 211a.

According to an embodiment, the (1-1)th sidewall 211a, the (1-2)th sidewall 211b, and the (1-3)th sidewall 211c of the first cover member 211 may be formed in a shape with one side (e.g., the front face) open to accommodate (or surround) at least a portion of the second housing portion 202. For example, at least a portion of the second housing portion 202 may be surrounded by the first housing portion 201 and be slid in the direction parallel to the first surface (e.g., the first surface F1 of FIG. 4), for instance, in the direction 1, while being guided by the first housing portion 201. According to an embodiment, the (1-1)th sidewall 211a, the (1-2)th sidewall 211b, and/or the (1-3)th sidewall 211c of the first cover member 211 may be integrally formed. According to an embodiment, the (1-1)th sidewall 211a, the (1-2)th sidewall 211b, and/or the (1-3)th sidewall 211c of the first cover member 211 may be formed as separate structures to be combined or assembled.

According to an embodiment, the first cover member 211 may be formed to surround at least a portion of the display 203. For example, at least a portion of the display 203 may be formed to be surrounded by the (1-1)th sidewall 211a, the (1-2)th sidewall 211b, and/or the (1-3)th sidewall 211c of the first cover member 211.

According to an embodiment, the second housing portion 202 may include a second cover member 221 (e.g., a slide plate). The second cover member 221 may have a plate shape and include a first surface (e.g., the first surface F1 of FIG. 4) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a (2-1)th sidewall 221a, a (2-2)th sidewall 221b extending from the (2-1)th sidewall 221a, and a (2-3)th sidewall 221c extending from the (2-1)th sidewall 221a and substantially parallel to the (2-2)th sidewall 221b. According to an embodiment, the (2-2)th sidewall 221b and the (2-3)th sidewall 221c may be formed substantially perpendicular to the (2-1)th sidewall 221a.

According to various embodiments, as the second housing portion 202 moves in a first direction (e.g., direction 1 of FIG. 3B) parallel to the (2-2)th sidewall 221b or the (2-3)th sidewall 221c, the slide-in state and the slide-out state of the electronic device 101 may be formed. In the slide-in state of the electronic device 101, the second housing portion 202 may be located at a first distance from the (1-1)th sidewall 211a of the first housing portion 201. In the slide-out state of the electronic device 101, the second housing portion 202 may move to be located at a second distance greater than the first distance from the (1-1)th sidewall 211a of the first housing portion 201. In an embodiment, in the slide-in state of the electronic device 101, the first housing portion 201 may be formed to surround a portion of the (2-2)th sidewall 221b and the (2-3)th sidewall 221c.

According to an embodiment, the electronic device 101 may have an intermediate state between the slide-in state (e.g., fully closed state) of FIGS. 2A-D and the slide-out state (e.g., fully opened state) of FIGS. 3A-D. The distance between the (1-1)th sidewall 211a and the (2-1)th sidewall 221a in the intermediate state of the electronic device 101 may be shorter than the distance between the (1-1)th sidewall 211a and the (2-1)th sidewall 221a of the electronic device 101 in the fully opened state and may be longer than the distance between the (1-1)th sidewall 211a and the (2-1)th sidewall 221a of the electronic device 101 in the fully closed state. According to an embodiment, as at least a portion of the display 203 slides in the intermediate state of the electronic device 101, the area exposed to the outside may vary. For example, in the intermediate state of the electronic device 101, the ratio of the width (e.g., length in the X direction) to the height (e.g., length in the Y direction) of the display 203 and/or the distance between the (1-1)th sidewall 211a and the (2-1)th sidewall 221a may be changed based on the slide movement of the electronic device 101.

According to an embodiment, the electronic device 101 may include the display 203, a key input device 245, a connector hole 243, audio modules (e.g., at least one speaker hole 247a and at least one microphone hole 247b, or camera modules (e.g., a first camera module 249a and a second camera module 249b). According to an embodiment, the electronic device 101 may further include an indicator (e.g., a light emitting diode (LED) device) or various sensor modules.

According to an embodiment, the display 203 may be formed so that the size of a portion of the housing 210, which may be viewed from the front, is changed based on sliding of the second housing portion 202. According to an embodiment, the display 203 may include the first display area A1 and the second display area A2 configured to be exposed to the outside of the electronic device 101 based on sliding of the second housing portion 202.

According to an embodiment, as the second housing portion 202 moves between a retracted position and an extended position with respect to the first housing portion 201, the size of the display 203 viewed toward the outer front face of the electronic device 101 may vary. For example, when the second housing portion 202 is located at a position (e.g., FIGS. 2A-D) retracted from the first housing portion 201, the size (or area) of the display 203 viewed toward the outer front surface of the electronic device 101 may be substantially minimized. In addition, when the second housing portion 202 is located at a position (e.g., FIGS. 3A-D) extending from the first housing portion 201, the size (or area) of the display 203 viewed toward the outer front surface of the electronic device 101 may be substantially maximized.

According to an embodiment, the first display area A1 may be disposed on the second housing portion 202. For example, the first display area A1 may be disposed on the second cover member 221 of the second housing portion 202. According to an embodiment, the second display area A2 may extend from the first display area A1, and as the second housing portion 202 slides relative to the first housing portion 201, the second display area A2 may be received in the first housing portion 201 or visually exposed to the outside of the electronic device 101. According to an embodiment, as the electronic device 101 changes from the slide-in state to slide-out state, the display 203 may extend in the downwards direction (e.g., -Y direction) of the electronic device 101. For example, in the slide-out state of the electronic device 101, the second display area A2 may be visually exposed from the downwards direction (e.g., -Y direction) of the display 203. According to an embodiment, as the electronic device 101 changes from the slide-in state to slide-out state, the display 203 may extend in the upwards direction (e.g., +Y direction) of the electronic device 101. For example, in the slide-out state of the electronic device 101, the second display area A2 may be visually exposed from the upwards direction (e.g., +Y direction) of the display 203.

According to an embodiment, the second display area A2 may be received in the space located inside the first housing portion 201 or exposed to the outside of the electronic device while being guided by one area (e.g., a guide rail 250 of FIG. 4) of the first housing portion 201. According to an embodiment, the second display area A2 may move based on sliding of the second housing portion 202 in the first direction (e.g., the direction 1). For example, while the second housing portion 202 slides, a portion of the second display area A2 may be deformed into a curved shape in a position corresponding to a curved surface 213a of the first housing portion 201.

According to an embodiment, when viewed from above the second cover member 221 (e.g., front cover) (e.g., from +Z direction or the front surface direction of the electronic device), if the electronic device 101 changes from the slide-in state to slide-out state (e.g., if the second housing portion 202 slides to extend from the first housing portion 201), the second display area A2 may gradually be exposed to the outside and, together with the first display area A1, form a substantially flat surface. According to an embodiment, the display 203 may be coupled with or disposed adjacent to a touch detection circuit, a pressure sensor capable of measuring the strength (e.g., pressure) of touches, and/or a digitizer for detecting a magnetic field-type stylus pen. According to an embodiment, irrespective of the slide-in state or slide-out state of the electronic device 101, a portion of the exposed second display area A2 may be located on a portion (e.g., the curved surface 213a of FIG. 4) of the first housing portion 201, and a portion of the second display area A2 may remain in the curved shape in the position corresponding to the curved surface 213a.

According to an embodiment, the key input device 245 may be located in an area of the housing 210 (e.g., the first housing portion 201 and/or second housing portion 202). Depending on the appearance and the state of use, the electronic device 101 may omit the key input device 245 or to include additional key input device(s). According to an embodiment, the electronic device 101 may include a key input device (e.g., a home key button or a touchpad disposed around the home key button). According to an embodiment, at least a portion of the key input device 245 may be disposed on the (1-1)th sidewall 211a, the (1-2)th sidewall 211b, or the (1-3)th sidewall 211c of the first housing portion 201. According to an embodiment, at least a portion of the key input device 245 may be disposed on the (2-1)th sidewall 221a, the (2-2)th sidewall 221b, and/or the (2-3)th sidewall 221c of the second housing portion 202.

According to an embodiment, the connector hole 243 may be omitted or may accommodate a connector (e.g., a universal serial bus (USB) connector) for transmitting and receiving power and/or data with an external electronic device. According to an embodiment, the electronic device 101 may include a plurality of connector holes 243, and some of the plurality of connector holes 243 may function as connector holes for transmitting/receiving audio signals with an external electronic device. In the illustrated embodiment, the connector hole 243 is located in the second housing portion 202, but is not limited thereto, and the connector hole 243 or another connector hole may be located in the first housing portion 201.

According to an embodiment, the audio modules may include at least one speaker hole 247a or at least one microphone hole 247b. One of the speaker holes 247a may be provided as a receiver hole for voice calls, and the other may be provided as an external speaker hole. The electronic device 101 may include a microphone for obtaining sound. The microphone may obtain external sound of the electronic device 101 through the microphone hole 247b. According to an embodiment, the electronic device 101 may include a plurality of microphones to detect the direction of sound. According to an embodiment, the electronic device 101 may include an audio module in which the speaker hole 247a and the microphone hole 247b are implemented as one hole or may include a speaker without the speaker hole 247a (e.g., a piezo speaker). According to an embodiment, the speaker hole 247a and the microphone hole 247b may be located in the first housing portion 201 and/or the second housing portion 202.

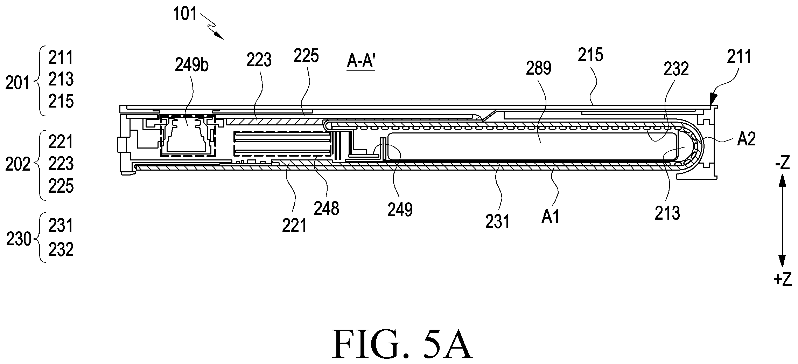

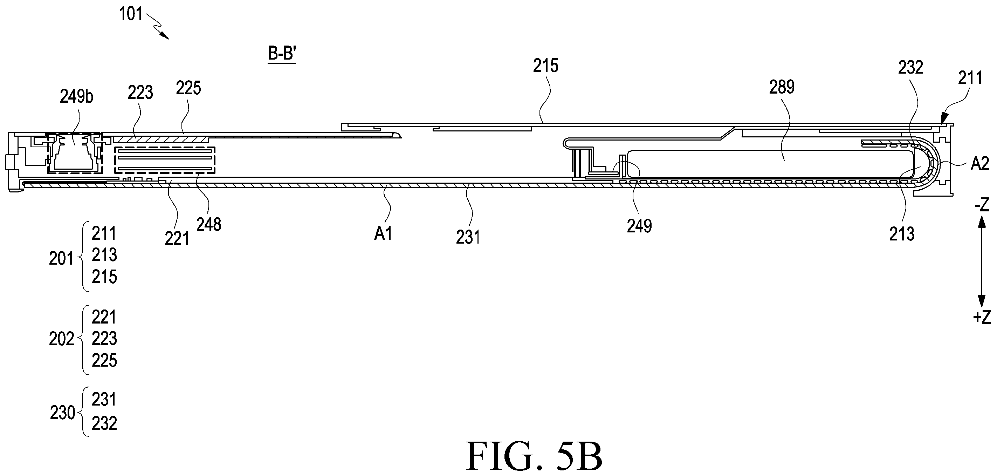

According to an embodiment, the camera modules may include a first camera module 249a (e.g., front camera) and/or a second camera module 249b (e.g., rear camera) (e.g., the second camera module 249b of FIGS. 5A and 5B). According to an embodiment, the electronic device 101 may include at least one from among a wide-angle camera, a telephoto camera, and a close-up camera. According to an embodiment, by including an infrared projector and/or an infrared receiver, it is possible to measure the distance to a subject. The camera modules may include one or more lenses, an image sensor, and/or an image signal processor. The first camera module 249a may be disposed to face in the same direction as a facing direction of the display 203. For example, the first camera module 249a may be disposed in an area around the first display area A1 or overlapping the display 203. When disposed in the area overlapping the display 203, the first camera module 249a may capture the subject through the display 203. According to an embodiment, the first camera module 249a may include an under-display camera (UDC) that is hidden and not visually exposed through the screen display area (e.g., the first display area A1). According to an embodiment, the second camera module 249b may capture the subject in a direction opposite to a facing direction of the first display area A1. According to an embodiment, the first camera module 249a and/or the second camera module 249b may be disposed on the second housing portion 202. According to an embodiment, a plurality of second camera modules 249b may be formed to provide various arrays. For example, the plurality of second camera modules 249b may be arranged along a width direction (e.g., X-axis direction) that is substantially perpendicular to the sliding movement direction (e.g., Y-axis direction) of the electronic device 101. In another example, the plurality of second camera modules 249b may be arranged along the sliding movement direction (e.g., Y-axis direction) of the electronic device 101. In another example, the plurality of second camera modules 249b may be arranged along N * M rows and columns like a matrix.

According to an embodiment, the second camera module 249b is not visually exposed to the outside of the electronic device 101 in the slide-in state of the electronic device 101 and, in the slide-out state of the electronic device 101, may capture the outside of the electronic device 101. According to an embodiment, the second camera module 249b may capture the outside of the electronic device 101 in the slide-in state and/or slide-out state of the electronic device 101. For example, at least a portion (e.g., a first rear plate 215 and/or a second rear plate 225 of FIG. 4) of the housing 210 may be substantially transparent. The second camera module 249b may capture the outside of the electronic device 101 through the first rear plate 215 and/or the second rear plate 225. According to an embodiment, the second camera module 249b may be visually exposed to the outside of the electronic device 101 to capture the outside of the electronic device 101 in the slide-in state and slide-out state of the electronic device 101. For example, the first housing portion 201 (e.g., the first rear plate 215 of FIG. 4) may include an opening 201a for the second camera module 249b.

According to an embodiment, an indicator of the electronic device 101 may be disposed on the first housing portion 201 or the second housing portion 202, and the indicator may include a light emitting diode to provide state information about the electronic device 101 as a visual signal. Sensor modules (e.g., a first sensor module 261a and a second sensor module 261b) of the electronic device 101 may produce an electrical signal or data value corresponding to an internal operation state or an external environment state of the electronic device 101. The sensor modules (e.g., the first sensor module 261a and the second sensor module 261b) may include a proximity sensor, a fingerprint sensor, and/or a biometric sensor (e.g., an iris/face recognition sensor or a heartrate monitor (HRM) sensor). In an embodiment, the sensor modules (e.g., the first sensor module 261a and the second sensor module 261b) may further include at least one from among a gesture sensor, a gyro sensor, an atmospheric pressure sensor, a magnetic sensor, an acceleration sensor, a grip sensor, a color sensor, an infrared (IR) sensor, a temperature sensor, a humidity sensor, and an illuminance sensor. According to an embodiment, the sensor modules (e.g., the first sensor module 261a and the second sensor module 261b )may be disposed in the first housing portion 201 and/or the second housing portion 202. For example, the sensor modules may include a first sensor module 261a (e.g., a proximity sensor or an illuminance sensor) disposed on the front surface of the electronic device 101 and/or a second sensor module 261b (e.g., a heart rate monitoring (HRM) sensor) disposed on the rear surface of the electronic device 101.

FIG. 4 is an exploded perspective view illustrating an electronic device according to an embodiment of the disclosure.

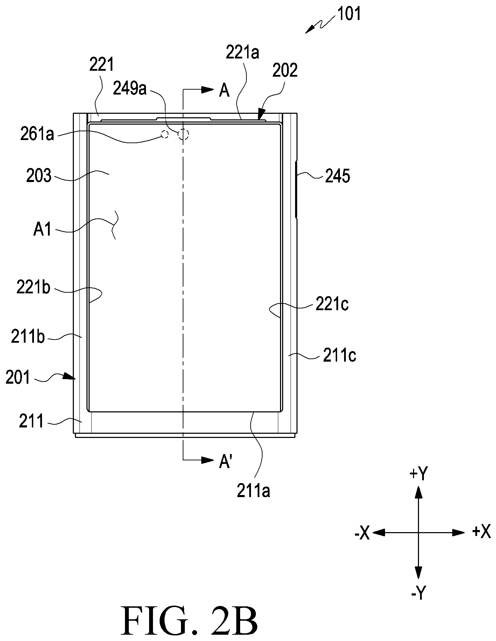

FIG. 5A is a cross-sectional view taken along the line A-A' of FIG. 2B, according to an embodiment of the disclosure.

FIG. 5B is a cross-sectional view taken along the line B-B' of FIG. 3B, according to an embodiment of the disclosure.

Referring to FIGS. 4, 5A, and/or 5B, an electronic device 101 (e.g., the electronic device 101 of FIGS. 1 to 3) may include a housing 210 that includes a first housing portion 201 and a second housing portion 202, a display assembly 230, and a driving structure 240. The configurations of the first housing portion 201, the second housing portion 202, and the display assembly 230 of FIG. 4, FIG. 5A, and/or FIG. 5B may be entirely or partially the same as the configurations of the housing 210, the first housing portion 201, the second housing portion 202, and the display 203 of FIGS. 2A-D and/or FIGS. 3A-D.

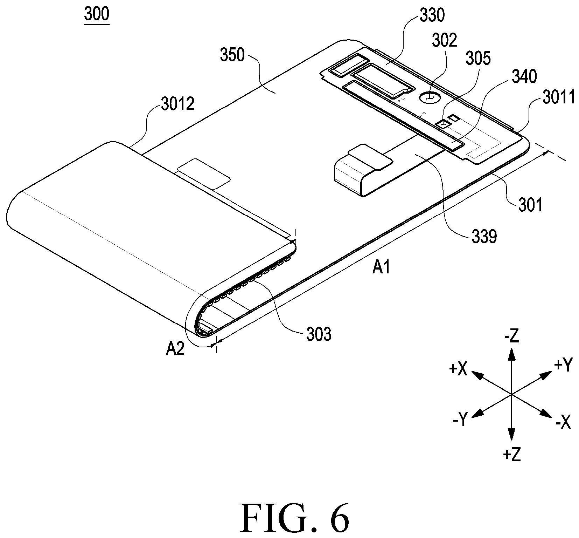

The embodiments of FIGS. 4 to 5B may be combined with the embodiments of FIGS. 1 to 3D or the embodiments of FIGS. 6 to 19.

According to an embodiment, the housing 210 may include a first housing portion 201 and/or a second housing portion 202 that is movably coupled to the first housing portion 201.

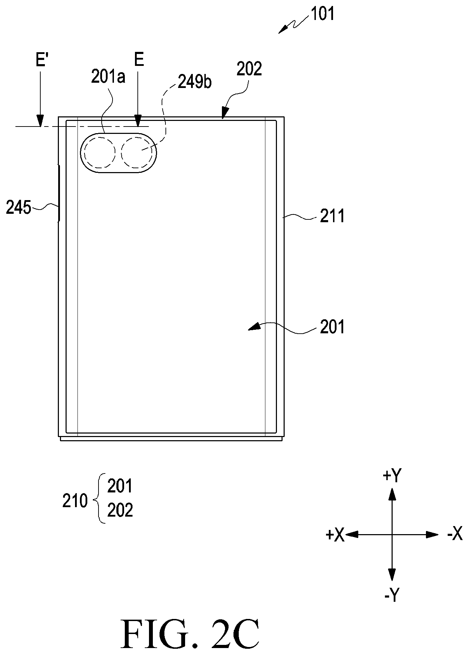

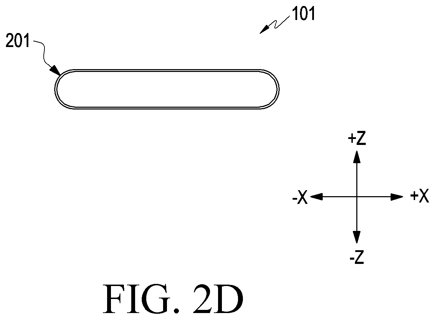

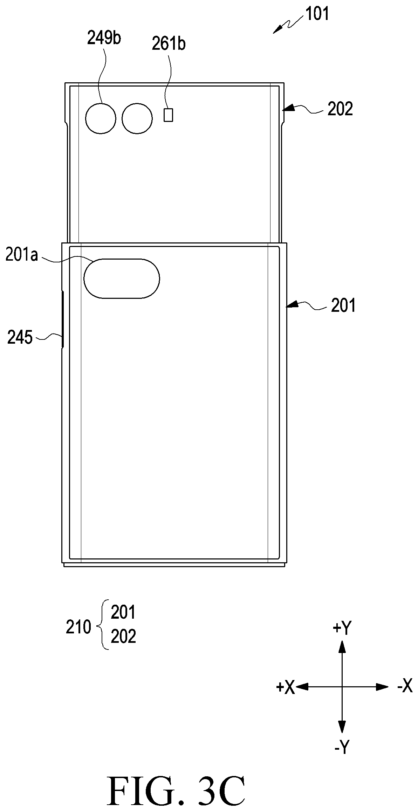

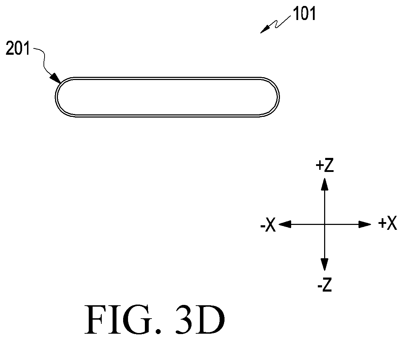

According to an embodiment, the first housing portion 201 may include a first cover member 211 (e.g., the first cover member 211 of FIGS. 2 and 3), a frame 213, and a first rear plate 215.

According to an embodiment, the first cover member 211 may accommodate at least a portion of the frame 213 and may accommodate a component (e.g., a battery 289) located in the frame 213. According to an embodiment, the first cover member 211 may be formed to surround at least a portion of the second housing portion 202. According to an embodiment, the first cover member 211 may protect components (e.g., a second circuit board 249 and the frame 213) located in the first housing portion 201 from external impacts. According to an embodiment, the second circuit board 249, which is electrically connected to an electrical component (e.g., an actuator, a speaker, a SIM socket, and/or the first circuit board 248), may be connected to the first cover member 211.

According to an embodiment, the frame 213 may be connected to the first cover member 211. For example, the frame 213 may be connected to the first cover member 211, and the second housing portion 202 may move relative to the first cover member 211 and/or frame 213. According to an embodiment, the frame 213 may accommodate the battery 289. For example, the frame 213 may include a groove to hold the battery 289. The frame 213 may be connected to a battery cover 289a and may surround at least a portion of the battery 289 together with the battery cover 289a. According to an embodiment, the frame 213 may include a curved surface 213a that faces the display assembly 230.

According to an embodiment, the first rear plate 215 may substantially form at least a portion of the exterior of the first housing portion 201 or the electronic device 101. For example, the first rear plate 215 may be coupled to the outer surface of the first cover member 211. According to an embodiment, the first rear plate 215 may provide a decorative effect on the exterior of the electronic device 101. The first rear plate 215 may be formed of at least one from among metal, glass, synthetic resin, and ceramic.

According to an embodiment, the second housing portion 202 may include a second cover member 221 (e.g., the second cover member 221 of FIGS. 2 and 3), a rear cover 223, and a second rear plate 225.

According to an embodiment, the second cover member 221 may be connected to the first housing portion 201 through a guide rail 250, and may perform a linear reciprocating motion in one direction (e.g., in the direction 1 of FIG. 3B) under the guidance of the guide rail 250.

According to an embodiment, the second cover member 221 may support at least a portion of the display 231. For example, the second cover member 221 may include a first surface F1, and the first display area A1 of the display 231 may be substantially located on the first surface F1 and maintained in a flat panel shape. According to an embodiment, the second cover member 221 may be formed of metal material and/or nonmetal material (e.g., polymer). According to an embodiment, a first circuit board 248, which accommodates electronic components (e.g., the processor 120 and/or memory 130 of FIG. 1) may be connected to the second cover member 221. According to an embodiment, the second cover member 221 may protect components (e.g., the first circuit board 248 and the rear cover 223) located in the second housing portion 202 from external impacts.

According to an embodiment, the rear cover 223 may protect components (e.g., the first circuit board 248) located on the second cover member 221. For example, the rear cover 223 may be connected to the second cover member 221 and formed to surround at least a portion of the first circuit board 248. According to an embodiment, the rear cover 223 may include an antenna pattern (e.g., at least one antenna element 223a) for communicating with external electronic devices. For example, the at least one antenna element 223a, when the rear cover 223 is formed of a dielectric material injection molding (e.g., an antenna carrier), may be disposed on the outer surface of the rear cover 223 (e.g., one surface facing the direction of the -Z-axis). For example, the at least one antenna element 223a may include a laser direct structuring (LDS) antenna pattern formed on the outer surface of the rear cover 223. For example, the at least one antenna element 223a may be formed by being embedded during the injection molding of the rear cover 223. For example, the at least one antenna element 223a may be configured to transmit or receive wireless signals in a specified frequency band (e.g., legacy band) by being electrically connected with a wireless communication circuit (e.g., the wireless communication module 192 of FIG. 1) disposed on the first circuit board 248.

According to an embodiment, the second rear plate 225 may substantially form at least a portion of the exterior of the second housing portion 202 or the electronic device 101. For example, the second rear plate 225 may be coupled to the outer surface of the second cover member 221. According to an embodiment, the second rear plate 225 may provide a decorative effect on the exterior of the electronic device 101. The second rear plate 225 may be formed of at least one from among metal, glass, synthetic resin, and ceramic.

According to an embodiment, the display assembly 230 may include the display 231 (e.g., the display 203 of FIGS. 2A-D and/or FIGS. 3A-D) and a multi-bar structure 232 supporting the display 231. According to an embodiment, the display 231 may be a flexible display, a foldable display, and/or a rollable display. According to an embodiment, the first display area A1 of the display 231 may be supported by a rigid body, and the second display area A2 may be supported by a bendable structure. For example, the first display area A1 may be supported by the first surface F1 of the second cover member 221 or a plate (e.g., a support plate 350 of FIG. 6). The second display area A2 may be supported by the multi-bar structure 232.

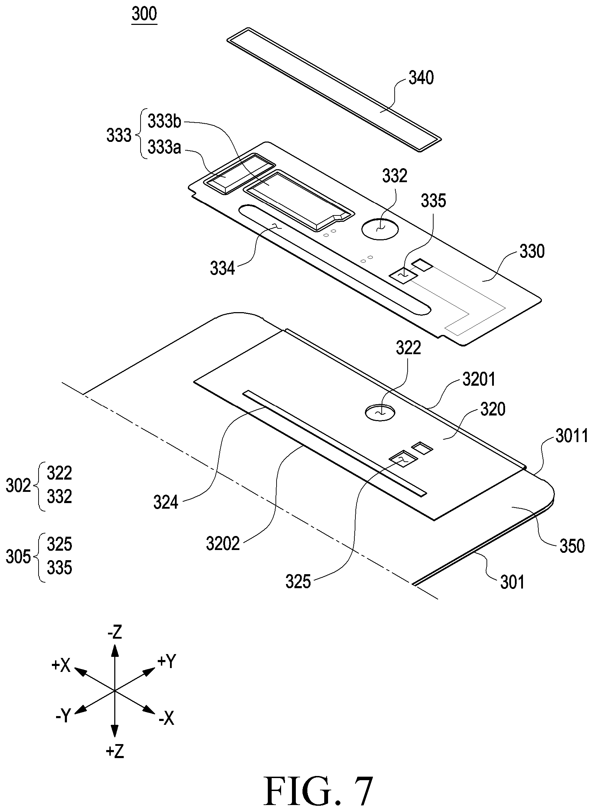

According to an embodiment, the display 231 may include a first end 2311 and/or a second end 2312. The first end 2311 may be defined as one edge or one end of the display 231. For example, the first end 2311 may form at least a portion of an edge or end of the first display area A1. The first end 2311 may be disposed substantially parallel to the (2-1)th sidewall (e.g., the (2-1)th sidewall 221a of FIGS. 2 to 3) of the second cover member 221. The second end 2312 may be defined as the other side edge or the other end of the display 231. For example, the second end 2312 may form at least a portion of the edge or end of the second display area A2. As the second display area A2 is at least partially bent with respect to the first display area A1, the second end 2312 may be located to face in substantially the same direction (e.g., the +Y direction of FIG. 4) as a facing direction of the first end 2311. The first end 2311 of the display 231 may be electrically connected to a first board (e.g., a first board 320 of FIG. 7) electrically connected to a display driver integrated circuit (e.g., a display driver integrated circuit 324 of FIG. 7).

According to an embodiment, the multi-bar structure 232 may be connected to or attached to at least a portion (e.g., the second display area A2) of the display 231. According to an embodiment, as the second housing portion 202 slides, the multi-bar structure 232 may move relative to the first housing portion 201. In the slide-in state of the electronic device 101(e.g., FIGS. 2A-D), the multi-bar structure 232 may be mostly accommodated in the first housing portion 201 and may be located between the first cover member 211 and the second cover member 221. According to an embodiment, at least a portion of the multi-bar structure 232 may move corresponding to the curved surface 213a located at the edge of the frame 213. According to an embodiment, the multi-bar structure 232 may be a display support member or a support structure, and may be in the form of a bendable plate.

According to an embodiment, the driving structure 240 may move the second housing portion 202 relative to the first housing portion 201. For example, the driving structure 240 may include an actuator 241 configured to generate a driving force for sliding the second housing portion 202 relative to the first housing portion 201. The driving structure 240 may include a gear 244 (e.g., a pinion) connected to the actuator 241 and a rack 242 configured to mesh with the gear. Referring to FIG. 4, components (e.g., the actuator 241, the rack 242, and the gear 244) of the driving structure 240 inverted (e.g., oriented towards the - Z-axis direction) within a circle P1 are illustrated.

According to an embodiment, the housing where the rack 242 is located and the housing where the actuator 241 is located may be different. According to an embodiment, the actuator 241 may be connected to the first housing portion 201, and the rack 242 may be connected to the second housing portion 202. According to an embodiment, the actuator 241 may be connected to the second housing portion 202, and the rack 242 may be connected to the first housing portion 201.

According to an embodiment, the actuator 241 may be controlled by a processor (e.g., the processor 120 of FIG. 1). For example, the processor 120 may include an actuator driver driving circuit and transmit a pulse width modulation (PWM) signal to the actuator 241 to control the speed of the actuator 241 and/or the torque of the actuator 241. According to an embodiment, the actuator 241 may be electrically connected to a processor (e.g., the processor 120 of FIG. 1) located on a circuit board (e.g., the first circuit board 248 of FIG. 4) using a flexible printed circuit board.

According to an embodiment, the second housing portion 202 may accommodate the first circuit board 248 (e.g., a main board). According to an embodiment, a processor, memory, and/or an interface may be mounted on the first circuit board 248. The processor may include, for example, one or more from among a central processing unit, an application processor, a graphic processing unit, an image signal processor, a sensor hub processor, and a communication processor. According to various embodiments, the first circuit board 248 may include a flexible printed circuit board type radio frequency cable (FRC). The first circuit board 248 may be disposed on at least a portion of the second cover member 221 and electrically connected to an antenna module (e.g., the antenna module 197 of FIG. 1) and a communication module (e.g., the communication module 190 of FIG. 1).

According to an embodiment, the memory may include, for example, volatile or non-volatile memory.

According to an embodiment, the interface may include, for example, a high definition multimedia interface (HDMI), a universal serial bus (USB) interface, a SD card interface, and/or an audio interface. The interface may electrically or physically connect, e.g., the electronic device 101 to an external electronic device and may include a USB connector, an SD card/multimedia card (MMC) connector, or an audio connector.

According to an embodiment, the electronic device 101 may include a second circuit board 249 (e.g., a sub-circuit board) spaced apart from the first circuit board 248 (e.g., a main circuit board) in the first housing portion 201. The second circuit board 249 may be electrically connected to the first circuit board 248 through a flexible board. The second circuit board 249 may be electrically connected to electrical components disposed in the end area of the electronic device 101, such as the battery 289, a speaker, and/or a SIM socket, to transmit signals and power. According to an embodiment, the second circuit board 249 may accommodate an antenna member 271 (e.g., a coil) or be connected to the antenna member 271. The antenna member 271 may include a multi-function coil (MFC) antenna, which includes a wireless charging antenna for a wireless charging functionality, an NFC antenna for a near field communication (NFC) functionality, and/or a magnetic secure transmission (MST) antenna for performing electronic payment functions. For example, the battery 289 may receive power from an external electronic device using the antenna member 271 for wireless charging. In another example, the battery 289 may transmit power to an external electronic device using the antenna member 271 for wireless charging.

According to an embodiment, the battery 289, serving as a device to supply power to at least one component of the electronic device 101, may include a non-rechargeable primary cell, a rechargeable secondary cell, or a fuel cell. The battery 289 may be integrally or detachably disposed inside the electronic device 101. According to an embodiment, the battery 289 may be formed as a single integrated battery or may include a plurality of removable batteries. According to an embodiment, the battery 289 may be located in the frame 213. For example, the battery 289 may be surrounded by the frame 213 and the battery cover 289a. According to an embodiment, the battery 289 may be located in the second housing portion 202 and may slide along with the second housing portion 202.

According to an embodiment, the guide rail 250 may guide the movement of the multi-bar structure 232. For example, the multi-bar structure 232 may slide along a slit 251 formed in the guide rail 250. According to an embodiment, the guide rail 250 may be connected to the first housing portion 201. For example, the guide rail 250 may be connected to the first cover member 211 and/or the frame 213. According to an embodiment, the slit 251 may be a groove or recess formed in the inner surface of the guide rail 250. Referring to FIG. 4, the guide rail 250 is shown in a circle P2.

According to an embodiment, the guide rail 250 may provide a force to the multi-bar structure 232 based on driving of the actuator 241.

According to an embodiment, when the electronic device 101 changes from the slide-in state to the slide-out state, at least a portion of the second housing portion 202 may, through driving of the actuator 241, slide out to become visually exposed to the outside from the first housing portion 201. For example, based on the driving of the actuator 241, the gear 244 may rotate in the first rotation direction. As the rack 242 is fixed on the second cover member 221 of the second housing portion 202, the second housing portion 202 may slide out to become visually exposed to the outside of the first housing portion 201 based on the sliding movement of the rack 242 towards the slide-out direction.

According to an embodiment, when the electronic device 101 changes from the slide-in state to the slide-out state, an inner portion 252 of the guide rail 250 may provide a force to the multi-bar structure 232. Upon receiving the force, the multi-bar structure 232 may move along the slit 251 of the guide rail 250, and the second housing portion 202 may slide to extend relative to the first housing portion 201. Consequently, at least a portion of the display assembly 230 accommodated between the first cover member 211 and the frame 213, may be extended to the front surface.

According to an embodiment, when the electronic device 101 changes from the slide-out state to the slide-in state, at least a portion of the second housing portion 202 may slide to be inserted into the first housing portion 201 through driving of the actuator 241. For example, based on the driving of the actuator 241, the gear 244 may rotate in a second rotation direction opposite to the first rotation direction. As the rack 242 is fixed on the second cover member 221 of the second housing portion 202, the second housing portion 202 may slide to enter into the first housing portion 201 based on the sliding movement of the rack 242 towards the slide-in direction.

According to an embodiment, when the electronic device 101 changes from the slide-out state to the slide-in state, the outer portion 253 of the guide rail 250 may provide a force to the multi-bar structure 232, that is bent. Upon receiving the force, the multi-bar structure 232 may move along the slit 251 of the guide rail 250, and at least a portion of the second housing portion 202 may slide to be received into the first housing portion 201. At least a portion of the display assembly 230 may be accommodated between the first cover member 211 and the frame 213.

According to an embodiment, the electronic device 101 may be configured to stop at a specified intermediate state between the slide-in state and the slide-out state by controlling driving of the actuator 241 (a free stop function). According to an embodiment, without the driving force being supplied to the actuator 241, the electronic device 101 may be transitioned to the slide-in state, the intermediate state, or the slide-out state through user manipulation.

Referring to FIG. 5A, in the slide-in state of the electronic device 101, at least a portion of the second housing portion 202 may be disposed to be received in the first housing portion 201. As the second housing portion 202 is disposed to be received in the first housing portion 201, the overall size of the electronic device 101 may be reduced. According to an embodiment, when the second housing portion 202 is received in the first housing portion 201, the size of the display 231, that is visually exposed, may be minimized. For example, when the second housing portion 202 is fully received in the first housing portion 201, the first display area A1 of the display 231 may be visually exposed, and at least a portion (e.g., a portion facing the -Z axis) of the second display area A2 may be disposed between the battery 289 and the first rear plate 215.

Referring to FIG. 5B, in the slide-out state of the electronic device 101, at least a portion of the second housing portion 202 may protrude from the first housing portion 201. As the second housing portion 202 protrudes from the first housing portion 201, the overall size of the electronic device 101 may increase. According to an embodiment, when the second housing portion 202 protrudes from the first housing portion 201, at least a portion of the second display area A2 of the display 231, along with the first display area A1, may be visually exposed to the outside of the electronic device 101.

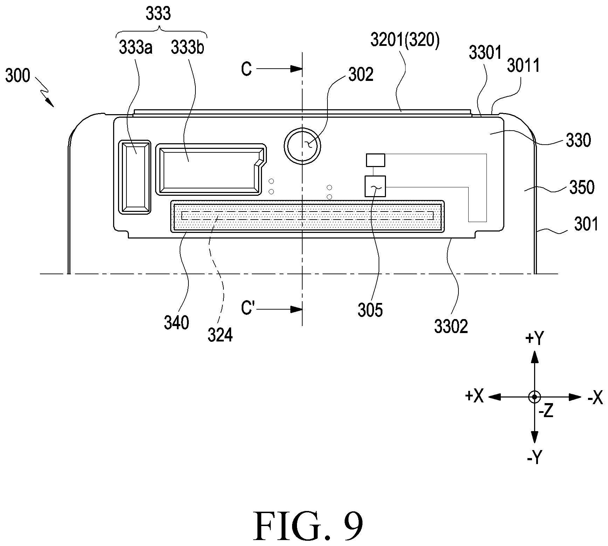

The embodiments of FIGS. 6 to 8 may be combined with the embodiments of FIGS. 1 to 5B or the embodiments of FIGS. 9 to 19.

Referring to FIGS. 6 to 8, a display assembly 300 (e.g., the display assembly 230 of FIG. 4) may include a display 301, a multi-bar structure 303, a first board 320, a second board 330, a shielding structure 340, and/or a support plate 350.

The display 301 or the multi-bar structure 303 of FIGS. 6 to 8 may be partially or entirely the same as the display 231 or the multi-bar structure 232 of FIGS. 4 to 5B.

According to an embodiment, the display 301 may be defined and/or referred to as a display panel or a flexible display. The display 301 may include a first display area A1 (e.g., the first display area A1 of FIGS. 4 to 5B) and/or a second display area A2 (e.g., the second display area A2 of FIGS. 4 to 5B). The second display area A2 may be supported by the multi-bar structure 303.

According to an embodiment, the display 301 may include a first end 3011 (e.g., the first end 2311 of FIG. 4) and/or a second end 3012 (e.g., the second end 2312 of FIG. 4). The first end 3011 (e.g., the first end 2311 of FIG. 4) of the display 301 may be electrically connected to the first board 320. The display 301 may be electrically connected to a display driver integrated circuit (DDI) 324 disposed on or mounted on the first board 320.

According to an embodiment, the support plate 350 may be configured to support the display 301. For example, the support plate 350 may be stacked on the inner surface of the display 301. The support plate 350 may provide or a force to maintain flatness or a force to flatten at least a portion of the display 301 that is visually exposed to the outside of the housing (e.g., the housing 210 of FIGS. 2A-D or FIG. 4). The support plate 350 may include a portion corresponding to the first display area A1 and a portion corresponding to the second display area A2. A portion of the support plate 350 corresponding to the second display area A2 may include at least one through-formed hole, or at least one groove that is formed to be recessed. The hole or groove may provide flexibility with respect to the support plate 350. For example, the support plate 350 may include a bendable metal material, but is not limited to this. According to an embodiment, at least a portion of the support plate 350 may be located between the display 301 and the first board 320, but is not limited thereto.

According to an embodiment, the first board 320 may be disposed on the inner surface of the display 301 (e.g., the surface facing the -Z direction of FIGS. 6 to 8). For instance, the first board 320 may be disposed on the inner surface of the first display area A1 (e.g., the surface facing the -Z direction of FIGS. 6 to 8). The inner surface of the display 301 and/or the first display area A1 may be defined as a surface facing the inside of an electronic device (e.g., the electronic device 101 of FIGS. 2 to 5B) or a surface that is not exposed to the outside of the electronic device. The inner surface of the first display area A1 may be supported by a first surface (e.g., the first surface F1 of FIG. 4) of a second cover member (e.g., the second cover member 221 of FIG. 4). The first board 320 may at least partially overlap with the display 301.

According to an embodiment, the first board 320 may be at least partially disposed between the display 301 and the second board 330.

According to an embodiment, the first board 320 may be electrically connected to the display 301. The first board 320 may provide an electrical path for connecting the display 301 and the display driver integrated circuit 324. For example, the first board 320 may include electrical wiring to provide the electrical path. The display driver integrated circuit 324 may be disposed or mounted on the first board 320. The first board 320 may include at least one from among a panel, plastic, glass, and film. The first board 320 may include a panel that allows the display driver integrated circuit 324 to be connected to the display 301 in a chip on panel (COP) manner. The first board 320 may include plastic that allows the display driver integrated circuit 324 to be connected to the display 301 in a chip on plastic (COP) manner. The first board 320 may include glass that allows the display driver integrated circuit 324 to be connected to the display 301 in a chip on glass (COG) manner. The first board 320 may include a film that allows the display driver integrated circuit 324 to be connected to the display 301 in a chip on film (COF) manner.

According to an embodiment, the display driver integrated circuit 324 may be disposed on the first board 320 and electrically connected to the display 301 through the electrical wiring of the first board 320. The display driver integrated circuit 324 may be configured to control the display 301. For example, the display driver integrated circuit 324 may be configured to control image output through the display 301.

According to an embodiment, the first board 320 may be disposed or stacked on the inner surface of the display 301 and/or the first display area A1. The first board 320 may be disposed between the display 301 (e.g., the first display area A1) and the second board 330.

According to an embodiment, the first board 320 may include a first portion 3201. The first portion 3201 may form one edge of the first board 320. The first portion 3201 may be configured to be at least partially bent. For example, the first portion 3201 may be bent from the edge of the first board 320 to be connected to the first end 3011 of the display 301. For instance, the first portion 3201 may be bent such that at least a portion of the first board 320 overlaps with the display 301. The first portion 3201 may be electrically connected to the first end 3011 of the display 301 and the first board 320. According to an embodiment, the first portion 3201 may be defined and/or interpreted as part of the display 301.

According to an embodiment, the first board 320 may include a second portion 3202 facing away from the first portion 3201. The second portion 3202 may be defined as a portion of the first board 320 located farthest from the first end 3011 of the display 301. The second portion 3202 may form the other side edge of the first board 320.

According to an embodiment, the display driver integrated circuit 324 may be disposed on or mounted on the first board 320. The display driver integrated circuit 324 may be located between the first portion 3201 and the second portion 3202.

According to an embodiment, the second board 330 may be disposed or stacked on one surface (e.g., the surface facing the -Z direction in FIGS. 6 to 8) of the first board 320. The second board 330 may at least partially overlap the first board 320. The second board 330 may include at least one from among a printed circuit board (PCB), a flexible PCB (FPCB), and a rigid-flexible PCB (RF-PCB). The second board 330 may include a film including a polyimide (PI) material.

According to an embodiment, the direction in which the second board 330 is stacked on the first board 320 (e.g., the Z-axis direction of FIGS. 6 to 8) may be defined and/or referred to as the second direction. The second direction may be different from the first direction (e.g., the Y-axis direction of FIGS. 2 to 5B or the Y-axis direction of FIGS. 6 to 8), which is the direction in which the second housing portion (e.g., the second housing portion 202 of FIGS. 2 to 5B) moves relative to the first housing portion (e.g., the first housing portion 201 of FIGS. 2 to 5B). The second direction may be substantially perpendicular to the first direction.

According to an embodiment, the second board 330 may include a second conductive connection member (e.g., the second conductive connection member 339 of FIG. 6). The second conductive connection member 339 may be electrically connected to the second board 330 and a main circuit board (e.g., the first circuit board 248 of FIG. 4). The second conductive connection member 339 may include at least one from among an FPCB, a conductive wire, and a conductive cable. The second conductive connection member 339 may be defined and/or interpreted as a separate component from the second board 330. According to an embodiment, the main circuit board (e.g., the first circuit board 248 of FIG. 4) may be disposed in the housing (e.g., the housing 210 of FIGS. 4 to 5B). The main circuit board may be spaced apart from the second board 330. At least one processor (e.g., the processor 120 of FIG. 1) may be mounted on the main circuit board. The main circuit board may be electrically connected to the second board 330 through the second conductive connection member 339.

According to an embodiment, the second board 330 may be electrically connected to the first board 320. As the second board 330 is electrically connected to the first board 320, the second board 330 may be also electrically connected to the display driver integrated circuit 324 disposed on the first board 320.

According to an embodiment, the second board 330 may be directly and electrically coupled to the first board 320 (e.g., FIG. 7). For instance, a conductive layer included in the second board 330 may be physically and/or electrically connected to the conductive layer included in the first board 320 or the conductive wiring included in the first board 320.

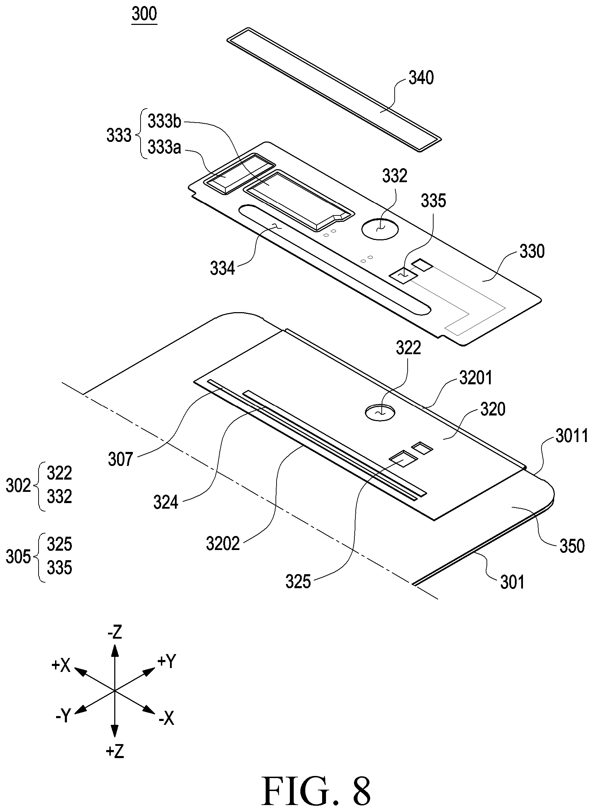

According to an embodiment, the second board 330 may be indirectly and electrically connected to the first board 320 through a separate member (e.g., FIG. 8). For example, the display assembly 300 may include a first conductive connection member 307. The second board 330 may be electrically connected to the first board 320 through the first conductive connection member (e.g., the first conductive connection member 307 of FIG. 8). The first conductive connection member 307 may include at least one from among a conductive pad, a conductive hot bar, a conductive soldering, and a conductive tape. The first conductive connection member 307 may be disposed between one surface of the first board 320 and one surface of the second board 330, which face each other. The first conductive connection member 307 may be electrically connected to both the first board 320 and the second board 330. The first conductive connection member 307 may be at least partially located between the display driver integrated circuit 324 and the second portion 3202, but is not limited thereto.

Referring to FIGS. 6 to 8, the second board 330 may include at least one electrical component 333. At least one electrical component 333 may be disposed or mounted on the second board 330. At least one electrical component 333 may include touch circuitry 333a and/or memory 333b (e.g., the memory 130 of FIG. 1). The touch circuitry 333a may include a touch sensor configured to sense a touch input to the display 301 or a pressure sensor capable of measuring the intensity (e.g., pressure) of the touch. The memory 333b may be disposed adjacent to the touch circuitry 333a. The memory 333b may store instructions. The instructions, when executed by the touch circuitry 333a or a processor (e.g., the processor 120 of FIG. 1), may cause the electronic device (e.g., the electronic device 101 of FIGS. 2A to 5B) to perform operations corresponding to or in response to a user's touch input. The types of the at least one electrical component 333 are not limited to those described above, and may include various electrical components that provide different functionalities for the electronic device or the display assembly 300.

According to an embodiment, the second board 330 may include an accommodation portion 334. The accommodation portion 334 may be formed in at least a portion of the second board 330. For example, the accommodation portion 334 may be formed at a position in the second board 330 corresponding to the display driver integrated circuit 324. The accommodation portion 334 may provide a space for accommodating the display driver integrated circuit 324 when the second board 330 is stacked on the first board 320. The accommodation portion 334 may have a sufficient size to accommodate the display driver integrated circuit 324. The accommodation portion 334 may surround the display driver integrated circuit 324.

According to an embodiment, the accommodation portion 334 may include a hole formed to penetrate from one surface (e.g., the surface facing the +Z direction of FIG. 7) of the second board 330 to the other surface (e.g., the surface facing the -Z direction of FIG. 7). According to an embodiment, the accommodation portion 334 may include a groove formed to be recessed from one surface of the second board 330 towards the other surface. The display driver integrated circuit 324 may be provided in chip form, and the chip-shaped display driver integrated circuit 324 may have a structure at least partially protruding from one surface (e.g., the surface facing the -Z direction in FIG. 7) of the first board 320. When the second board 330 is stacked on the first board 320, at least a portion of the display driver integrated circuit 324 may be accommodated in the accommodation portion 334 of the second board 330. As the display driver integrated circuit 324 is accommodated in the accommodation portion 334, the combined thickness of the first board 320 and the second board 330 or the thickness of the display assembly 300 may be provided to be thin. According to an embodiment, the accommodation portion 334 may be defined as a physical space where the display driver integrated circuit 324 is accommodated. For example, the accommodation portion 334 may include a hole, a groove, an opening, a recess, or a slit formed in the second board 330 to accommodate or cover the display driver integrated circuit 324. According to an embodiment, the accommodation portion 334 may be defined as a portion of the second board 330 that is in contact with or overlaps the display driver integrated circuit 324. For instance, the second board 330, which may be made of a flexible material, may come into contact with the display driver integrated circuit 324 and may be at least partially bent or stepped to cover the display driver integrated circuit 324. The accommodation portion 334 may be defined as at least a portion of the second board 330 that is modified by the display driver integrated circuit 324 or in contact and/or overlaps the display driver integrated circuit 324.

According to an embodiment, the shielding structure 340 may be disposed on the second board 330. For example, the shielding structure 340 may be disposed on the second board 330 to cover the accommodation portion 334. The shielding structure 340 may be disposed to cover the display driver integrated circuit 324. The shielding structure 340 may include a shield-can or a shielding sheet. The shielding structure 340 may be configured to block or reduce noise acting between electrical components of an electronic device (e.g., the electronic device 101 of FIGS. 2A to 5B) and the display driver integrated circuit 324. The shielding structure 340 may be configured to shield the display driver integrated circuit 324. The shielding structure 340 may be disposed along the inner edge of the second board 330 defining the accommodation portion 334. The shielding structure 340 may be configured to provide a shielding function by being electrically connected to a ground plane of the second board 330.

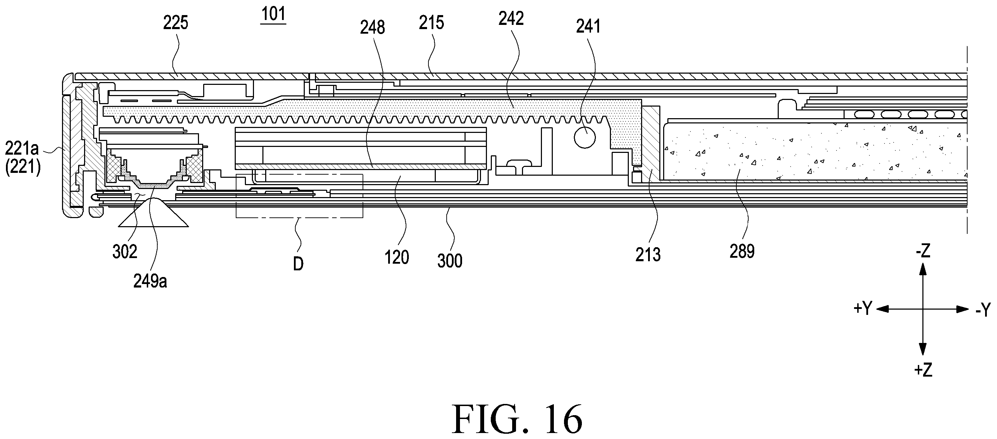

According to an embodiment, along the thickness direction (e.g., the Z-axis direction of FIGS. 6 to 8 or the Z-axis direction of FIGS. 16 to 18) of the electronic device (e.g., the electronic device 101 of FIGS. 2A to 5B) or the display assembly 300, the first board 320, the second board 330, and the shielding structure 340 may be sequentially stacked. This sequential stacking of the first board 320, the second board 330, and the shielding structure 340 along the thickness direction may improve the integration density of components in the display assembly 300. With the increased integration density of the display assembly 300, the space for accommodating a battery (e.g., the battery 289 of FIG. 4) in the electronic device may be increased. For example, as the first board 320, the second board 330, and the shielding structure 340 of the display assembly 300 are stacked along the thickness direction, the mounting space for the battery may increase in a direction (e.g., the Y-axis direction of FIGS. 6 to 8) substantially perpendicular to the thickness direction. The direction substantially perpendicular to the thickness direction may be defined as a longitudinal direction (e.g., the Y-axis direction of FIGS. 6 to 8) in relation to the electronic device or the display assembly 300. The longitudinal direction of the electronic device or the display assembly 300 may be substantially the same as the direction (e.g., the Y-axis direction of FIGS. 2A to 3D) in which the second housing portion (e.g., the second housing portion 202 of FIGS. 2A to 5B) moves relative to the first housing portion (e.g., the first housing portion 201 of FIGS. 2A to 5B).

According to an embodiment, the display assembly 300 may include openings (e.g., a first opening 302 and a second opening 305). The openings (e.g., the first opening 302 and the second opening 305) may be located to be aligned with at least one from among a camera (e.g., the first camera module 249a of FIG. 2B) and a sensor (e.g., the first sensor module 261a of FIG. 2B).

According to an embodiment, the display assembly 300 may include a first opening 302 located to correspond to a front camera (e.g., the first camera module 249a of FIG. 2A) of an electronic device (e.g., the electronic device 101 of FIGS. 2A to 5B). The front camera may capture a subject through the display 301. The front camera may capture a subject through the first opening 302. The front camera may be at least partially accommodated within or aligned with the first opening 302. The front camera may include an under-display camera (UDC) configured to not be visually exposed through the first display area A1.

According to an embodiment, the first opening 302 may include a first opening area 322 formed in the first board 320 and/or a second opening area 332 formed in the second board 330. The second opening area 332 may be located to correspond to the first opening area 322. For example, the second opening area 332 may overlap the first opening area 322. The first opening 302 may be formed as a combination of the first opening area 322 and the second opening area 332.

According to an embodiment, the display assembly 300 may include a second opening 305 located to correspond to a sensor (e.g., the first sensor module 261a of FIG. 2B) of an electronic device (e.g., the electronic device 101 of FIGS. 2A to 5B). The sensor may include a proximity sensor or an illuminance sensor. The sensor may be at least partially accommodated within or aligned with the second opening 305. The second opening 305 may be spaced apart from the first opening 302. The second opening 305 may include a third opening area 325 formed in the first board 320 and/or a fourth opening area 335 formed in the second board 330. The fourth opening area 335 may be located to correspond to the third opening area 325. For example, the fourth opening area 335 may overlap the third opening area 325. The second opening 305 may be formed as a combination of the third opening area 325 and the fourth opening area 335.

According to an embodiment, the display driver integrated circuit 324 may be located between the first portion 3201 of the first board 320 and the second portion 3202 of the first board 320. The first opening 302 may be located between the first portion 3201 and the display driver integrated circuit 324. The second opening 305 may be located between the first portion 3201 and the display driver integrated circuit 324.

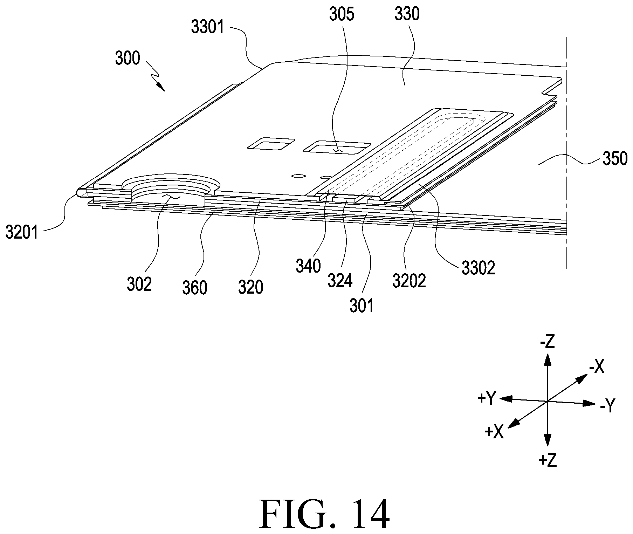

The embodiments of FIGS. 9 to 13 may be combined with the embodiments of FIGS. 1 to 8, or the embodiments of FIGS. 14 to 19.

Referring to FIGS. 9 to 13, the display assembly 300 (e.g., the display assembly 300 of FIGS. 6 to 8) may include a display 301, a first opening 302, a first opening 3021, a second opening 305, a second opening 3051, a first board 320, a display driver integrated circuit 324, a display driver integrated circuit 3241, a second board 330, at least one electrical component 333, a shielding structure 340, a shielding structure 3401, and/or a support plate 350.

The configurations of the display 301, the first opening 302, the first opening 3021, the second opening 305, the second opening 3051, the first board 320, the display driver integrated circuit 324, the display driver integrated circuit 3241, the second board 330, the at least one electrical component 333, the shielding structure 340, and the shielding structure 3401, and/or the support plate 350 of FIGS. 9 to 13 may be partially or entire the same as the configurations of the display 301, the first opening 302, the second opening 305, the first board 320, the display driver integrated circuit 324, the second board 330, the at least one electrical component 333, the shielding structure 340, and/or the support plate 350 of FIGS. 6 to 8.

Referring to FIGS. 9 to 11, the first opening 302 may be formed by overlapping a first opening area (e.g., the first opening area 322 of FIGS. 7 to 8) formed in the first board (e.g., the first board 320 of FIGS. 6 to 8) and a second opening area (e.g., the second opening area 332 of FIGS. 7 to 8) formed in the second board 330. A front camera (e.g., the first camera module 249a of FIGS. 2A-D) of an electronic device (e.g., the electronic device 101 of FIGS. 2A to 5B) may be disposed and/or located in the first opening 302. The first opening 302 may be located to be aligned with the front camera.

According to an embodiment, the second opening 305 may be formed by overlapping a third opening area (e.g., the third opening area 325 of FIGS. 7 to 8) formed in the first board (e.g., the first board 320 of FIGS. 6 to 8) and a fourth opening area (e.g., the fourth opening area 335 of FIGS. 7 to 8) formed in the second board 330. A sensor (e.g., the first sensor module 261a of FIGS. 2A-D) of an electronic device (e.g., the electronic device 101 of FIGS. 2 to 5B) may be disposed and/or located in the second opening 305. The second opening 305 may be located to be aligned with the sensor.

According to an embodiment, the display driver integrated circuit 324 may be disposed on the first board (e.g., the first board 320 of FIGS. 6 to 8) and may be covered by the shielding structure 340. The shielding structure 340 may be disposed on the second board 330.

According to an embodiment, at least one electrical component 333 (e.g., the at least one electrical component 333 of FIGS. 7 to 8) may be disposed on the second board 330. The at least one electrical component 333 may include touch circuitry 333a (e.g., the touch circuitry 333a of FIGS. 7 to 8) and/or memory 333b (e.g., the memory 333b of FIGS. 7 to 8).

According to an embodiment, the second board 330 may include a first edge 3301 and/or a second edge 3302. The first edge 3301 may be substantially parallel to the first portion 3201 (e.g., the first portion 3201 of FIGS. 7 to 8) of the first board 320 or the first end 3011 (e.g., the first end 3011 of FIGS. 7 to 8) of the display 301. The first edge 3301 may face in substantially the same direction as the first portion 3201 (e.g., the first portion 3201 of FIGS. 7 to 8) of the first board 320 or the first end 3011 of the display 301. The second edge 3302 may face in an opposite direction to the first edge 3301. The second edge 3302 may be defined as a portion of the second board 330 located farthest from the first end 3011 of the display 301. The first edge 3301 may form one edge of the second board 330. The second edge 3302 may form the other side edge of the second board 330. The second edge 3302 may be disposed adjacent to the second portion (e.g., the second portion 3202 of FIGS. 7 to 8).

According to an embodiment, the display driver integrated circuit 324 mounted on the first board 320 may be located between the first edge 3301 and the second edge 3302 when viewed in the thickness direction (e.g., the Z-axis direction of FIGS. 6 to 13) of the display assembly 300. The display driver integrated circuit 324 may be disposed closer to the second edge 3302 than to the first edge 3301.

According to an embodiment, the first opening 302 may be located between the first edge 3301 and the second edge 3302 when viewed in the thickness direction of the display assembly 300. The first opening 302 may be located between the first edge 3301 and the display driver integrated circuit 324 when viewed in the thickness direction of the display assembly 300. The first opening 302 may be located between the first portion 3201 and the second portion (e.g., the second portion 3202 of FIGS. 7 to 8). The first opening 302 may be located between the first portion 3201 and the display driver integrated circuit 324.

According to an embodiment, the second opening 305 may be located between the first edge 3301 and the second edge 3302 when viewed in the thickness direction of the display assembly 300. The second opening 305 may be located between the first edge 3301 and the display driver integrated circuit 324 when viewed in the thickness direction of the display assembly 300. The second opening 305 may be located between the first portion 3201 and the second portion (e.g., the second portion 3202 of FIGS. 7 to 8). The second opening 305 may be located between the first portion 3201 and the display driver integrated circuit 324.

According to an embodiment, the second opening 305 may be spaced apart from the first opening 302.

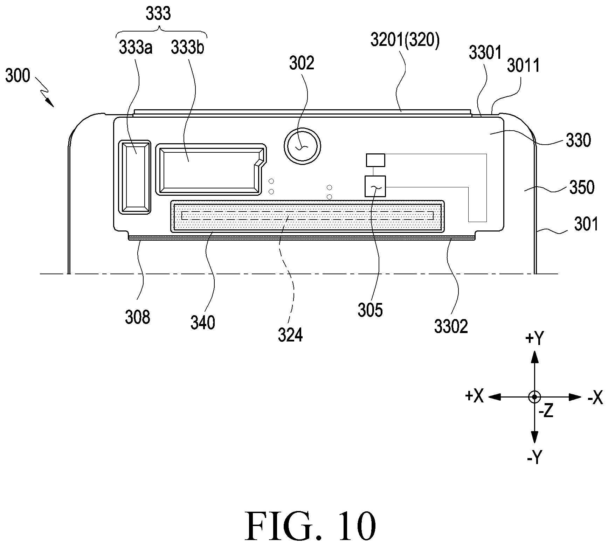

Referring to FIG. 10, the display assembly 300 may include a cover portion 308. The cover portion 308 may be disposed to cover the second edge 3302 of the second board 330. For example, the cover portion 308 may include foam, bond, or resin. The cover portion 308 may cover the second edge 3302 of the second board 330 and the second portion (e.g., the second portion 3202 of FIGS. 7 to 8) of the first board 320. The cover portion 308 may be configured to supplement the rigidity of the second edge 3302 of the second board 330 and the second portion of the first board 320, or to limit and/or reduce the occurrence of cracks. According to an embodiment, the cover portion 308 may be defined and/or referred to as a reinforcement portion, a bracket, or a support member.

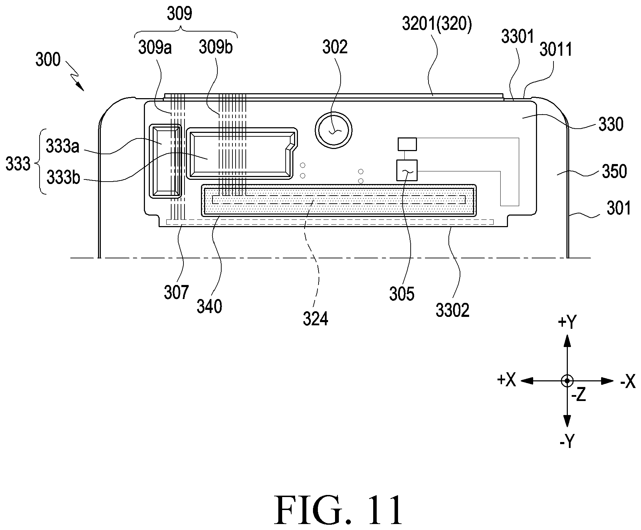

Referring to FIG. 11, the display assembly 300 may include at least one wiring 309. The at least one wiring 309 may be disposed on the first board 320. The at least one wiring 309 may extend from the first portion 3201 of the first board 320 towards the second portion 3202 of the first board 320. The second board 330 and/or the first board 320 may be electrically connected to the display 301 through the at least one wiring 309.

According to an embodiment, the at least one wiring 309 may include a first wiring 309a and/or a second wiring 309b. The first wiring 309a may be configured to be electrically connected to the touch circuitry 333a and the display 301. The first wiring 309a may extend from the first portion 3201 of the first board 320 to the first conductive connection member 307 (e.g., the first conductive connection member 307 of FIG. 8) disposed on the first board 320. The first wiring 309a may be electrically connected to the display 301 and the first conductive connection member 307. For example, signals corresponding to a user's touch input and/or signals corresponding to a user's touch pressure may be transmitted to the touch circuitry 333a through the first wiring 309a, the first conductive connection member 307, and the second board 330. The second wiring 309b may be configured to be electrically connected to the display driver integrated circuit 324 and the display 301. The second wiring 309b may extend from the first portion 3201 of the first board 320 to the display driver integrated circuit 324 disposed on the first board 320. The second wiring 309b may transmit control signals provided by the display driver integrated circuit 324 to the display 301.

According to an embodiment, the first wiring 309a or the second wiring 309b may be located to avoid the first opening 302 and/or the second opening 305, but is not limited thereto. According to an embodiment, additional wirings may be provided to transmit signals other than those mentioned above.

According to an embodiment, the first wiring 309a and/or the second wiring 309b may extend in a first direction (e.g., the Y-axis direction of FIGS. 2A to 5B or the Y-axis direction of FIG. 11), which is the direction in which the second housing portion (e.g., the second housing portion 202 of FIGS. 2A to 5B) moves relative to the first housing portion (e.g. the first housing portion 201 in FIGS. 2A to 5B). The length of the first wiring 309a in the first direction may be defined and/or referred to as a first length. The length of the second wiring 309b in the first direction may be defined and/or referred to as a second length. The first length may differ from the second length. For example, the first length may be longer than the second length. The first length may be substantially the same as the second length.

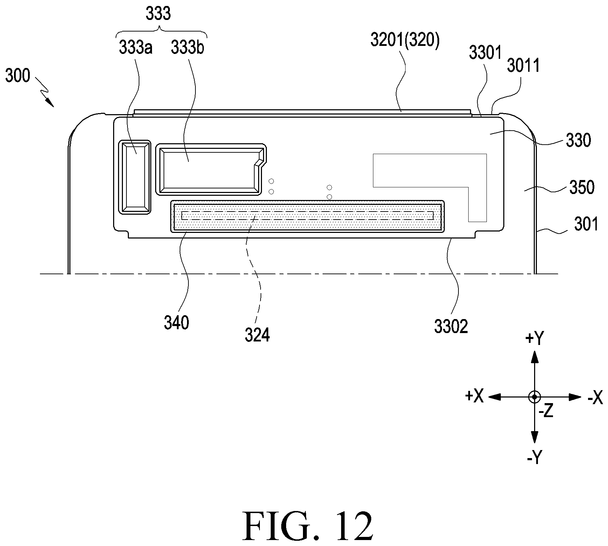

Referring to FIG. 12, the display assembly 300 may not include an opening configured for the placement of a front camera or a sensor. In the display assembly 300, which does not include an opening for placing the front camera or the sensor, the placement of the at least one wiring 309, as described with reference to FIG. 11, may not be restrictive.

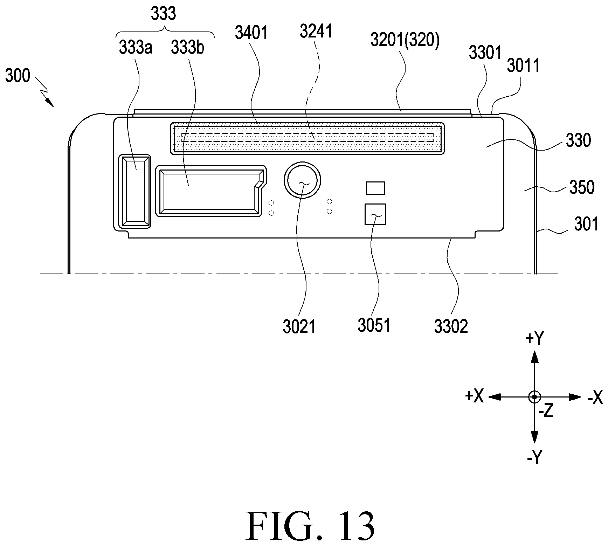

Referring to FIG. 13, the display driver integrated circuit 3241 disposed on the first board 320 may be located between the first edge 3301 and the second edge 3302 when viewed in the thickness direction (e.g., the Z-axis direction of FIGS. 6 to 13) of the display assembly 300. The display driver integrated circuit 324 may be disposed closer to the first edge 3301 than to the second edge 3302.

According to an embodiment, the first opening 3021 may be located between the first edge 3301 and the second edge 3302 when viewed in the thickness direction of the display assembly 300. The first opening 3021 may be located between the display driver integrated circuit 3241 and the second edge 3302 when viewed in the thickness direction of the display assembly 300. The first opening 3021 may be located between the first portion 3201 and the second portion (e.g., the second portion 3202 of FIGS. 7 to 8). The first opening 3021 may be located between the display driver integrated circuit 3241 and the second portion (e.g., the second portion 3202 of FIGS. 7 to 8).

According to an embodiment, the second opening 3051 may be located between the first edge 3301 and the second edge 3302 when viewed in the thickness direction of the display assembly 300. The second opening 3051 may also be located between the display driver integrated circuit 3241 and the second edge 3302 when viewed in the thickness direction of the display assembly 300. The second opening 3051 may be located between the first portion 3201 and the second portion (e.g., the second portion 3202 of FIGS. 7 to 8). The second opening 3051 may be located between the display driver integrated circuit 3241 and the second portion (e.g., the second portion 3202 of FIGS. 7 to 8).

According to an embodiment, the second opening 3051 may be spaced apart from the first opening 3021.

FIG. 14 is a cross-sectional perspective view taken along a line C-C' of FIG. 9, according to an embodiment of the disclosure.

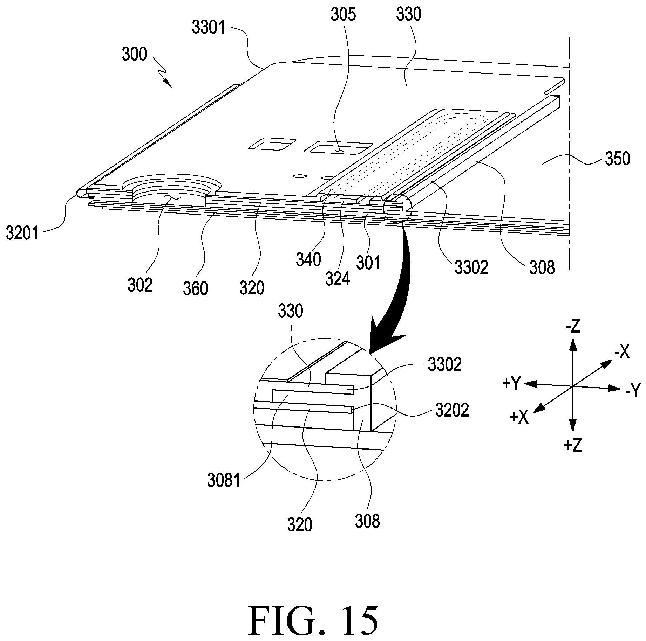

FIG. 15 is a cross-sectional perspective view taken along the line C-C' of FIG. 9, according to an embodiment of the disclosure.

The embodiments of FIGS. 14 to 15 may be combined with the embodiments of FIGS. 1 to 13, or the embodiments of FIGS. 16 to 19.

Referring to FIGS. 14 to 15, the display assembly 300 (e.g., the display assembly 300 of FIGS. 6 to 13) may include a display 301, a first opening 302, a second opening 305, a first board 320, a display driver integrated circuit 324, a second board 330, a shielding structure 340, a support plate 350, and/or a display cover member 360.

The configurations of the display 301, the first opening 302, the second opening 305, the first board 320, the first portion 3201, the second portion 3202, the display driver integrated circuit 324, the second board 330, the first edge 3301, the second edge 3302, the shielding structure 340, and/or the support plate 350 of FIGS. 14 to 15 may be partially or entirely the same as the configurations of the first opening 302, the second opening 305, the first board 320, the first portion 3201, the second portion 3202, the display driver integrated circuit 324, the display driver integrated circuit 3241, the second board 330, the first edge 3301, the second edge 3302, the shielding structure 340, the shielding structure 3401, and/or the support plate 350 of FIGS. 6 to 13.

According to an embodiment, the first board 320 and the second board 330 may be sequentially stacked on the inner surface (e.g., the surface facing in the -Z direction in FIGS. 14 to 15) of the display 301. For example, the first board 320 may be stacked on the inner surface of the display 301, and the second board 330 may be stacked on the inner surface of the first board 320.

According to an embodiment, the display driver integrated circuit 324 may overlap the shielding structure 340 with respect to a direction (e.g., the Z-axis direction of FIGS. 14 to 15) in which the second board 330 is stacked with respect to the first board 320. The shielding structure 340 may be disposed to cover the display driver integrated circuit 324.

According to an embodiment, the second board 330 may be disposed to overlap the first board 320 based on the thickness direction (e.g., the Z-axis direction of FIGS. 2 to 15) of the display assembly 300 and/or the electronic device (e.g., the electronic device 101 of FIGS. 2 to 5B). As the second board 330 overlaps the first board 320 in the thickness direction, the space occupied by the coupling structure of the second board 330 and the first board 320 in a direction perpendicular to the thickness direction (e.g., the Y-axis direction of FIGS. 2 to 15) may be reduced. Consequently, a space available for mounting a battery (e.g., the battery 289 of FIG. 4) in a direction perpendicular to the thickness direction may be increased, and the capacity or size of the battery disposed or mounted in the electronic device may be increased.

According to an embodiment, the first portion 3201 may extend from the first board 320 and may be connected to the first end (e.g., the first end 3011 of FIGS. 7 to 8) of the display 301. The first portion 3201 may have a bent shape.

According to an embodiment, the display driver integrated circuit 324 may be electrically connected to the display 301 through the first board 320 and the first portion 3201.

According to an embodiment, the second portion 3202 of the first board 320 may be disposed parallel to the second edge 3302 of the second board 330.

According to an embodiment, the display assembly 300 may include a display cover member 360. The display cover member 360 may be disposed or stacked on an outer surface of the display 301. The display cover member 360 may include a cover window, a coating film, or a polarizing layer.

Referring to FIG. 15, the display assembly 300 may include a cover portion 308 (e.g., the cover portion 308 of FIG. 10). The cover portion 308 may be configured to cover the second edge 3302 of the second board 330 and the second portion 3202 of the first board 320. At least a portion 3081 of the cover portion 308 may be located between the second board 330 and the first board 320. For example, at least the portion 3081 of the cover portion 308 may be located between the second edge 3302 and the second portion 3202. At least the portion 3081 of the cover portion 308 may be defined and/or referred to as a spacer configured to fill a gap formed between the edge of the first board 320 and the edge of the second board 330. When external impacts are applied to the edges of the second board 330 and the first board 320, the external impacts may be absorbed by at least the portion 3081 of the cover portion 308.

FIG. 16 is a cross-sectional view illustrating an electronic device according to an embodiment of the disclosure.

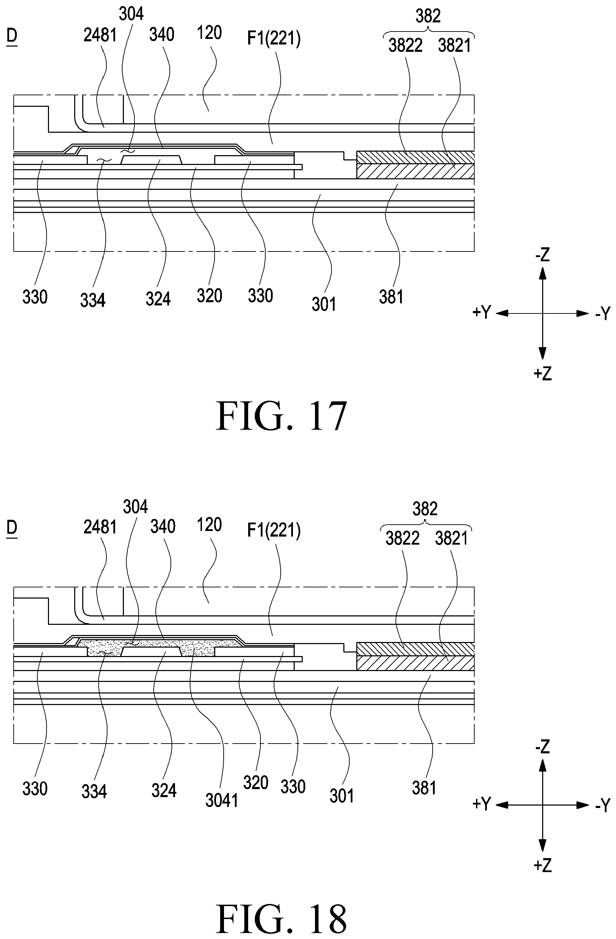

FIG. 17 is an enlarged view of a part D of FIG. 16 according to an embodiment of the disclosure.

FIG. 18 is an enlarged view of the part D of FIG. 16 according to an embodiment of the disclosure.

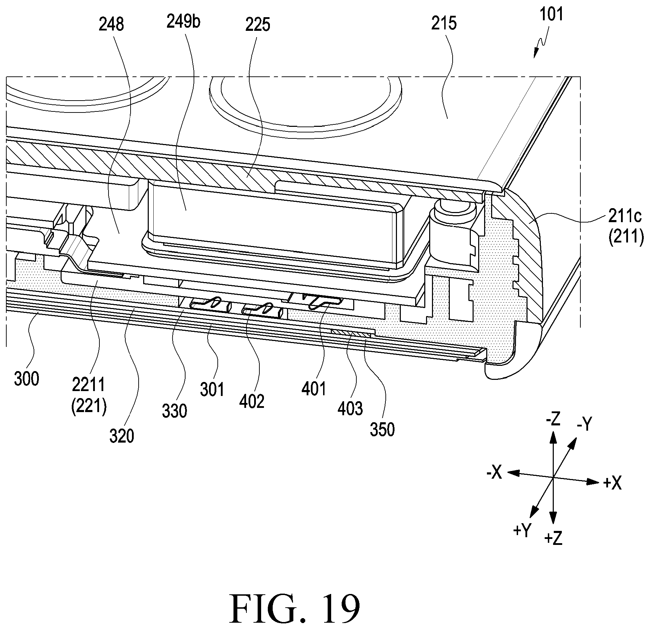

The embodiments of FIGS. 16 to 18 may be combined with the embodiments of FIGS. 1 to 15, or the embodiment of FIG. 19.

Referring to FIGS. 16 to 18, an electronic device 101 (e.g., the electronic device 101 of FIGS. 2A to 5B) may include at least one processor 120, a frame 213, a first rear plate 215, a second cover member 221, a second rear plate 225, an actuator 241, a rack 242, a first circuit board 248, a battery 289, a front camera (e.g., a first camera module 249a), and/or a display assembly 300.

The configuration of the at least one processor 120 of FIGS. 16 to 18 may be partially or entirely the same as the configuration of the processor 120 of FIG. 1. The configurations of the frame 213, the first rear plate 215, the second cover member 221, the second rear plate 225, the actuator 241, the rack 242, the first circuit board 248, and/or the battery 289 of FIGS. 16 to 18 may be partially or entirely the same as the configurations of the frame 213, the first rear plate 215, the second cover member 221, the second rear plate 225, the actuator 241, the rack 242, the first circuit board 248, and/or the battery 289 of FIG. 4. The configuration of the front camera (e.g., the first camera module 249a) of FIGS. 16 to 18 may be partially or entirely the same as the configuration of the first camera module 249a of FIGS. 2A-D. The configuration of the display assembly 300 of FIGS. 16 to 18 may be partially or entirely the same as the configuration of the display assembly 300 of FIGS. 6 to 15.

According to an embodiment, the display assembly 300 may include a first opening 302 (e.g., the first opening 302 of FIGS. 6 to 15) located to be aligned with the front camera (e.g., the first camera module 249a). The front camera (e.g., the first camera module 249a) may be configured to capture a subject through the first opening 302. The front camera (e.g., the first camera module 249a) may be located adjacent to the (2-1)th sidewall 221a (e.g., the (2-1)th sidewall 221a of FIGS. 2A-D) of the second cover member 221.

According to an embodiment, the display assembly 300 may include a display 301 (e.g., the display 231 of FIG. 4 or the display 301 of FIGS. 6 to 15). The display assembly 300 may include a first board 320 (e.g., the first board 320 of FIGS. 6 to 15) disposed on at least a portion of the inner surface (e.g., the surface facing the -Z direction of FIGS. 16 to 18) of the display 301. The display driver integrated circuit 324 (e.g., the display driver integrated circuit 324 of FIGS. 6 to 15) may be disposed on or mounted on the first board 320.

According to an embodiment, the second board 330 (e.g., the second board 330 of FIGS. 6 to 15) may be disposed on the first board 320. The second board 330 may include an accommodation portion 334 (e.g., the accommodation portion 334 of FIGS. 7 to 8) to accommodate the display driver integrated circuit 324. A shielding structure 340 (e.g., the shielding structure 340 of FIGS. 6 to 15) may be disposed on the second board 330, which defines the accommodation portion 334. The shielding structure 340 may be configured to block and/or reduce noise generated by the processor 120 and/or other electrical components from being transmitted to the display driver integrated circuit 324. The shielding structure 340 may be electrically connected to a ground plane of the second board 330.

According to an embodiment, the at least one processor 120 may be mounted on the first circuit board 248. The first circuit board 248 may be spaced apart from the second board 330. At least one processor 120 may be covered by a shield can 2481. The shield can 2481 may be configured to block and/or reduce noise generated by the display driver integrated circuit 324 and/or other electrical components from being transmitted to the at least one processor 120. The shield can 2481 may be electrically connected to a ground plane of the first circuit board 248.

According to an embodiment, the shielding structure 340 may face the first surface F1 (e.g., the first surface F1 of FIG. 4) of the second cover member 221.

According to an embodiment, the display assembly 300 may include a cushion layer 381 and/or a heat dissipation layer 382. The cushion layer 381 may be disposed on the inner surface (e.g., the surface facing the -Z direction of FIGS. 17 to 18) of the display 301. The cushion layer 381 may be configured to protect the display 301 from external impacts. The cushion layer 381 may include emboss or tape. The heat dissipation layer 382 may be disposed on the inner surface of the display 301. The heat dissipation layer 382 may be disposed on the inner surface (e.g., the surface facing the -Z direction of FIGS. 17 to 18) of the cushion layer 381. The heat dissipation layer 382 may be configured to block and/or reduce heat generated within the electronic device 101 from being transferred to the display 301. The heat dissipation layer 382 may be configured to diffuse heat generated from the display 301 or from the at least one processor 120. The heat dissipation layer 382 may include a vapor chamber or graphite. For example, the heat dissipation layer 382 may include a vapor chamber and a first heat dissipation layer 3821 stacked on the inner surface of the cushion layer 381. The heat dissipation layer 382 may include graphite, and the heat dissipation layer 382 may further include a second heat dissipation layer 3822 stacked on the inner surface of the first heat dissipation layer 3821. According to an embodiment, the second heat dissipation layer 3822 may be stacked on the inner surface of the cushion layer 381, and the first heat dissipation layer 3821 may be stacked on the inner surface of the second heat dissipation layer 3822.

According to an embodiment, the first board 320, the second board 330, and the shielding structure 340 may be configured to overlap in the thickness direction (e.g., the Z-axis direction of FIGS. 16 to 18) of the display assembly 300 and/or the electronic device 101. The display driver integrated circuit 324 and the shielding structure 340 may be configured to overlap in the thickness direction (e.g., the Z-axis direction of FIGS. 16 to 18) of the display assembly 300 and/or the electronic device 101.

According to an embodiment, the second board 330 may be stacked on the first board 320 in the second direction (e.g., the Z-axis direction of FIGS. 16 to 18). The second direction may be different from the first direction (e.g., the Y-axis direction of FIGS. 2 to 5B or the Y-axis direction of FIGS. 6 to 8), which is a direction in which the second housing portion (e.g., the second housing portion 202 of FIGS. 2 to 5B) moves relative to the first housing portion (e.g., the first housing portion 201 of FIGS. 2 to 5B). The second direction may be substantially perpendicular to the first direction.

According to an embodiment, the battery 289 may not overlap the first board 320 and the second board 330 in the second direction (e.g., the Z-axis direction of FIGS. 16 to 18).

According to an embodiment, the heat dissipation layer 382 may not overlap the first board 320 and the second board 330 in the second direction (e.g., the Z-axis direction of FIGS. 16 to 18).

According to an embodiment, as the integration density of the display assembly 300 improves in the thickness direction of the display assembly 300 and/or the electronic device 101, the space available for accommodating the battery 289, the cushion layer 381, and/or the heat dissipation layer 382 may increase. For example, as the first board 320, the second board 330, and the shielding structure 340 of the display assembly 300 are stacked along the thickness direction, the space of placing the battery 289, the cushion layer 381, and/or the heat dissipation layer 382 in a direction (e.g., the Y-axis direction of FIGS. 15 to 17) substantially perpendicular to the thickness direction may increase. In the case of the heat dissipation layer 382, since the heat dissipation layer 382 does not overlap the first board 320 and the second board 330 in the thickness direction (or the second direction), the heat dissipation layer 382 may have a planar surface structure rather than a stepped structure.

According to an embodiment, an accommodation space 304 may be formed between the shielding structure 340 and the first board 320. The accommodation space 304 may be defined by the shape of the shielding structure 340 and the accommodation portion 334. For example, the display driver integrated circuit 324 may be disposed in the accommodation space 304. The accommodation space 304 may be defined as an air gap.

Referring to FIG. 18, the display assembly 300 may include a heat dissipation member 3041 disposed in or filling the accommodation space 304. The heat dissipation member 3041 may include thermal interface materials (TIM). The heat dissipation member 3041 may include foam disposed in or filling in the accommodation space 304. The heat dissipation member 3041 may be disposed in the accommodation space 304 to reduce and/or mitigate heat generated from the processor 120 from being transferred to the display driver integrated circuit 324. The heat dissipation member 3041 may be configured to diffuse heat generated from the display 301. As the heat dissipation member 3041 is filled in the accommodation space 304, impacts applied to the shielding structure 340 may be absorbed or mitigated. Additionally, the likelihood of damage or deformation to the shielding structure 340 or the display driver integrated circuit 324 due to external impacts may be limited and/or reduced.

According to an embodiment, the accommodation space 304 may be filled with a filler material (e.g., resin or thermal interface material (TIM)). As the filler material fills the accommodation space 304, it may limit and/or reduce the transmission of the external impacts to the display driver integrated circuit 324 and/or the shielding structure 340. The display driver integrated circuit 324 and/or the shielding structure 340 may enhance or improve rigidity against external impacts due to the filler material.

FIG. 19 is a cross-sectional perspective view of an electronic device taken along line E-E' of FIG. 2C, according to an embodiment of the disclosure.

The embodiment of FIG. 19 may be combined with the embodiments of FIGS. 1 to 18.

Referring to FIG. 19, an electronic device 101 (e.g., the electronic device 101 of FIGS. 2 to 5B or the electronic device 101 of FIG. 16) may include a first cover member 211, a first rear plate 215, a second rear plate 225, a first circuit board 248, a rear camera (e.g., a second camera module 249b), a display assembly 300, a display 301, a first board 320, a second board 330, and/or a support plate 350.

The configurations of the first cover member 211, the first rear plate 215, the second rear plate 225, and/or the first circuit board 248 of FIG. 19 may be partially or entirely the same as the configurations of the first cover member 211, the first rear plate 215, the second rear plate 225, and/or the first circuit board 248 of FIG. 4. The configuration of the rear camera (e.g., the second camera module 249b) of FIG. 19 may be partially or entirely the same as the configuration of the second camera module 249b of FIG. 3C. The configuration of the display assembly 300, the display 301, the first board 320, the second board 330, and/or the support plate 350 of FIG. 19 may be partially or entirely the same as the configurations of the display assembly 300, the display 301, the first board 320, the second board 330, and/or the support plate 350 of FIGS. 6 to 18.

According to an embodiment, the rear camera (e.g., the second camera module 249b) may be disposed or mounted on the first circuit board 248.

According to an embodiment, the rear camera (e.g., the second camera module 249b) may be located adjacent to the (1-3)th side wall 211c (e.g., the (1-3)th side wall 211c of FIGS. 2A to 3D) of the first cover member 211.

According to an embodiment, the electronic device 101 may include a first conductive contact member 401. The first conductive contact member 401 may include a C-clip or a conductive member disposed on the first circuit board 248. The first conductive contact member 401 may come into contact with a metal portion 2211 of the second cover member 221. The metal portion 2211 may form at least a portion of a first surface (e.g., the first surface F1 of FIG. 4) of the second cover member 221. The metal portion 2211 may provide a ground.

According to an embodiment, the electronic device 101 may include a second conductive contact member 402. The second conductive contact member 402 may include a C-clip or a conductive member disposed on the second board 330. The second conductive contact member 402 may come into contact with a metal portion 2211 of the second cover member 221.

According to an embodiment, the electronic device 101 may include a third conductive contact member 403. The third conductive contact member 403 may include a conductive tape disposed on the second board 330. The third conductive contact member 403 may come into contact with the second board 330 and the support plate 350.

According to an embodiment, the second board 330 may be electrically connected to the ground provided by the metal portion 2211 of the second cover member 221 through the second conductive contact member 402. The second board 330 may be electrically connected to the ground of the first circuit board 248 through the second conductive contact member 402, the metal portion 2211, and the first conductive contact member 401. The second board 330 may be electrically connected to the ground provided by the support plate 350 through the third conductive contact member 403. The second board 330 may be electrically connected to the ground provided from various positions through the conductive contact members (e.g., the first conductive contact member 401, the second conductive contact member 402, and the third conductive contact member 403). Consequently, the second board 330 may provide a shielding function to reduce and/or limit the transmission of noise to a touch circuitry (e.g., the touch circuitry 333a of FIGS. 7 to 8) disposed on the second board 330 and a display driver integrated circuit (e.g., the display driver integrated circuit 324 of FIGS. 6 to 18) disposed on the first board 320.

According to an embodiment, the display driver integrated circuit (e.g., the display driver integrated circuit 324 of FIGS. 6 to 18) and/or the touch circuitry (e.g., the touch circuitry 333a of FIGS. 7 to 8) may overlap the rear camera (e.g., the second camera module 249b) in the second direction (e.g., the Z-axis direction of FIG. 19), which is a direction in which the second board 330 is stacked on the first board 320.

According to an embodiment, the electronic device 101 may include electrical components such as a vibration motor (e.g., the haptic module 179 of FIG. 1). The display driver integrated circuit (e.g., the display driver integrated circuit 324 of FIGS. 6 to 18) and/or the touch circuitry (e.g., the touch circuitry 333a of FIGS. 7 to 8) may not overlap electrical components such as a vibration motor in the second direction (e.g., the Z-axis direction of FIG. 19). The electronic device 101 may be provided such that the display driver integrated circuit, the touch circuitry, the first board 320, and the second board 330 overlap each other in the second direction, thereby increasing a space for placing and/or mounting electrical components such as a vibration motor. The electronic device 101 may be provided such that the display driver integrated circuit, the touch circuitry, the first board 320, and the second board 330 overlap each other in the second direction, thereby increasing a space for placing a main circuit board (e.g., the first circuit board 248 of FIG. 4).

An electronic device including a display may have a limitation in implementing a screen larger than the size of the electronic device due to a fixed display structure. Therefore, electronic devices including a rollable display may be provided.

An electronic device including a rollable display may have the size of the display area and/or the size of a partial area of the electronic device expand or contract when a sliding operation is implemented.

An electronic device including a rollable display may include components (e.g., an actuator or a gear structure) to implement a sliding operation in the electronic device. Upon implementing the sliding operation in the electronic device, the rollable display may be at least partially bent and retracted into the electronic device. The rollable display may include a display driver integrated circuit (DDI). The display driver integrated circuit may be electrically connected to the main circuit board of the electronic device through a separate component (e.g., FPCB).

An electronic device including a rollable display may face challenges in securing a sufficient space for mounting a battery due to components required to implement the sliding operation, a space occupied by the display within the electronic device, or components such as an FPCB.

According to an embodiment of the disclosure, an electronic device may be provided where a space for mounting a battery is enhanced through the improved coupling structure of the display driver integrated circuit, the first board, and the second board.

However, the problems solved by embodiments of the disclosure are not limited to those mentioned above, and other problems may be solved by embodiments of the disclosure.

According to an embodiment of the disclosure, by stacking components for mounting the display driver integrated circuit and components providing shielding functions for the display driver integrated circuit in the thickness direction of the electronic device, it is possible to provide an electronic device capable of securing sufficient space for mounting a battery and a heat dissipation sheet in the longitudinal direction of the electronic device.

The effects obtained by embodiments of the disclosure are not limited to those mentioned above, and other effects of embodiments of the disclosure that are not mentioned can be clearly understood by those of ordinary skill in the art within the technical field to which this disclosure belongs.

According to an embodiment, an electronic device 101 may include a flexible display (e.g., the display 301), a first board 320, a display driver integrated circuit 324, a second board 330, and/or a shielding structure 340. The first board 320 may at least partially overlap the flexible display (e.g., the display 301). The first board 320 may be electrically connected to the flexible display (e.g., the display 301). The display driver integrated circuit 324 may be disposed on the first board 320. The second board 330 may at least partially overlap the first board 320. The second board 330 may be electrically connected to the first board 320. The second board 330 may include an accommodation portion 334. The accommodation portion 334 may accommodate at least a part of the display driver integrated circuit 324. The shielding structure 340 may be disposed on the second board 330. The shielding structure 340 may cover the accommodation portion 334. The shielding structure 340 may be configured to shield the display driver integrated circuit 324.

According to an embodiment, the first board 320 may include a first portion 3201 and/or a second portion 3202. The first portion 3201 may be connected to a first end 3011 of the flexible display (e.g., the display 301). The second portion 3202 may face in an opposite direction to the first portion 3201. The first portion 3201 may be bent such that at least a portion of the first board 320 overlaps the flexible display (e.g., the display 301). The display driver integrated circuit 324 may be located between the first portion 3201 and the second portion 3202.

According to an embodiment, the electronic device 101 may further include openings (e.g., a first opening 302 and a second opening 305). The openings (e.g., the first opening 302 and the second opening 305) may be formed in the first board 320 and the second board 330. The openings (e.g., the first opening 302 and the second opening 305) may be located to be aligned with at least one from among a camera (e.g., the first camera module 249a) and a sensor (e.g., a first sensor module 261a).

According to an embodiment, the openings (e.g., the first opening 302 and the second opening 305) may be located between the first portion 3201 and the display driver integrated circuit 324.

According to an embodiment, the openings (e.g., the first opening 3021 and the second opening 3051) may be located between the second portion 3202 and the display driver integrated circuit 3241.

According to an embodiment, the second board 330 may include a first edge 3301 and/or a second edge 3302. The first edge 3301 may face in substantially the same direction as the first portion 3201. The second edge 3302 may face in an opposite direction to the first edge 3301. The second edge 3302 may be disposed adjacent to the second portion 3202.

According to an embodiment, the electronic device 101 may further include a cover portion 308. The cover portion 308 may cover the second edge 3302 and the second portion 3202.

According to an embodiment, the cover portion 308 may include a spacer (e.g., portion 3081) disposed between the first board 320 and the second board 330.

According to an embodiment, the first board 320 may be at least partially located between the display 301 and the second board 330.

According to an embodiment, the electronic device 101 may further include a housing 210. The housing 210 may include a first housing portion 201 and/or a second housing portion 202. The second housing portion 202 may be configured to move with respect to the first housing portion 201 in a first direction. The flexible display (e.g., the display 301) may be disposed on the housing 210. The second board 330 may be stacked on the first board 320 in a second direction different from the first direction.

According to an embodiment, the second direction may be substantially perpendicular to the first direction.

According to an embodiment, the electronic device 101 may further include a battery 289. The battery 289 may be disposed in the housing 210. The battery 289 may not overlap the first board 320 and the second board 330 in the second direction.

According to an embodiment, the electronic device 101 may further include a heat dissipation layer 382. The heat dissipation layer 382 may be disposed on the inner surface of the flexible display (e.g., the display 301). The heat dissipation layer 382 may not overlap the first board 320 and the second board 330 in the second direction.

According to an embodiment, the electronic device 101 may further include touch circuitry 333a, a main circuit board (e.g., a first circuit board 248), and/or at least one processor 120. The touch circuitry 333a may be mounted on the second board 330. The main circuit board (e.g., the first circuit board 248) may be disposed within the housing 210. The main circuit board (e.g., the first circuit board 248) may be electrically connected to the second board 330. The at least one processor 120 may be mounted on the main circuit board (e.g., the first circuit board 248).

According to an embodiment, the electronic device 101 may further include a heat dissipation member 3041. The heat dissipation member 3041 may be disposed in the accommodation space 304. The accommodation space 304 may be defined by the accommodation portion 334 and the shielding structure 340.

According to an embodiment, an electronic device 101 may include a housing 210, a flexible display (e.g., the display 301), a first board 320, a display driver integrated circuit 324, a second board 330, and/or a shielding structure 340. The housing 210 may include a first housing portion 201 and/or a second housing portion 202. The second housing portion 202 may be configured to move with respect to the first housing portion 201 in a first direction. The flexible display (e.g., the display 301) may be disposed on the housing 210. The first board 320 may be stacked on the flexible display (e.g., the display 301). The display driver integrated circuit 324 may be disposed on the first board 320. The second board 330 may be stacked on the first board 320 in a second direction different from the first direction. The second board 330 may be electrically connected to the first board 320. The second board 330 may include an accommodation portion 334. The accommodation portion 334 may accommodate at least a part of the display driver integrated circuit 324. The shielding structure 340 may be disposed on the second board 330. The shielding structure 340 may be electrically connected to a ground plane of the second board 330. The shielding structure 340 may cover the display driver integrated circuit 324.

According to an embodiment, the electronic device 101 may further include a conductive connection member (e.g., the first conductive connection member 307) and/or at least one electrical component 333. The conductive connection member (e.g., the first conductive connection member 307) may be electrically connected to the first board 320 and the second board 330. The at least one electrical component 333 may be mounted on the second board 330.

According to an embodiment, the first board 320 may include a first wiring 309a and/or a second wiring 309b. The first wiring 309a may be electrically connected to the flexible display (e.g., the display 301) and the first conductive connection member 307. The second wiring 309b may be electrically connected to the flexible display (e.g., the display 301) and the display driver integrated circuit 324.

According to an embodiment, a first length of the first wiring 309a in the first direction may be longer than a second length of the second wiring 309b in the second direction.

According to an embodiment, the electronic device 101 may further include a support plate 350 and/or a conductive contact member (e.g., a third conductive contact member 403). The support plate 350 may be configured to support an inner surface of the flexible display (e.g., the display 301). The conductive contact member (e.g., the third conductive contact member 403) may be in contact with the second board 330 and the support plate 350.

While non-limiting example embodiments of the disclosure have been described above with reference to the drawings, it will be apparent to those of ordinary skill in the art that various changes in form and detail may be made thereto without departing from the spirit and scope of the disclosure.

## Claims

1. An electronic device comprising:
a flexible display;
a first board at least partially overlapping the flexible display and electrically connected to the flexible display;
a display driver integrated circuit on the first board;
a second board at least partially overlapping the first board, electrically connected to the first board, and including an accommodation portion accommodating at least a part of the display driver integrated circuit; and
a shielding structure on the second board, covering the accommodation portion, and configured to shield the display driver integrated circuit.

2. The electronic device of claim 1, wherein the first board comprises a first portion connected to a first end of the flexible display and a second portion facing in a direction opposite to a facing direction of the first portion,
wherein the first portion is bent such that at least a portion of the first board overlaps the flexible display, and
wherein the display driver integrated circuit is between the first portion and the second portion.

3. The electronic device of claim 2, wherein an opening is formed in the first board and the second board,
wherein the opening is aligned with at least one from among a camera and a sensor of the electronic device.

4. The electronic device of claim 3, wherein the opening is between the first portion and the display driver integrated circuit.

5. The electronic device of claim 3, wherein the opening is between the second portion and the display driver integrated circuit.

6. The electronic device of claim 2, wherein the second board comprises a first edge facing in a same direction as the facing direction of the first portion, and further comprises a second edge facing in an direction opposite of the facing direction of the first edge, and
wherein the second edge is adjacent to the second portion.

7. The electronic device of claim 6, further comprising a cover portion covering the second edge and the second portion.

8. The electronic device of claim 7, wherein the cover portion comprises a spacer between the first board and the second board.

9. The electronic device of claim 1, wherein the first board is at least partially between the flexible display and the second board.

10. The electronic device of claim 1, further comprising a housing comprising a first housing portion and a second housing portion configured to move with respect to the first housing portion in a first direction,
wherein the flexible display is on the housing, and
wherein the second board is on the first board in a second direction different from the first direction.

11. The electronic device claim 10, wherein the second direction is perpendicular to the first direction.

12. The electronic device of claim 11, further comprising a battery in the housing,
wherein the battery does not overlap the first board and the second board in the second direction.

13. The electronic device of claim 11, further comprising a heat dissipation layer on an inner surface of the flexible display,
wherein the heat dissipation layer does not overlap the first board and the second board in the second direction.

14. The electronic device of claim 10, further comprising:
touch circuitry on the second board;
a main circuit board in the housing, and electrically connected to the second board; and
at least one processor on the main circuit board.

15. The electronic device of claim 1, further comprising a heat dissipation member in an accommodation space,
wherein the accommodation space is defined by the accommodation portion and the shielding structure.
